# EUROPEAN PATENT APPLICATION

(11) **EP 4 489 006 A2**
(43) Date of publication of application: **08.01.2025**
(21) Application number: 24183146.0
(22) Date of filing: 19.06.2024
(51) Int. Cl.: G11C 16/26, G11C 11/56, G11C 16/04, G11C 16/08, G11C 16/24

(54) **MEMORY DEVICE**

(30) Priority: 07.07.2023 JP 2023112068
(71) Applicant: Kioxia Corporation, Tokyo 108-0023 (JP)
(72) Inventor: Maejima, Hiroshi, Minato-ku,Tokyo 108-0023 (JP)
(74) Representative: Hoffmann Eitle

(57) **Abstract**

A memory device according to one embodiment includes includes bit lines, strings, first and second wirings, a word line, and a sequencer. Each of the strings has one end coupled to the bit lines. Each of the strings includes a memory cell, and first and second transistors coupled in series. The first wiring is coupled to the first transistor of each of the strings. The second wiring is coupled to the second transistor of each of the strings. The word line is coupled to the memory cell of each of the strings. The sequencer is configured to, in a read operation of N bytes in which the word line is selected, apply a first voltage to one of the first wiring line and the second wiring line, and apply a second voltage higher than the first voltage to the other of the first wiring line and the second wiring line.

## Description

### CROSS-REFERENCE TO RELATED APPLICATIONS

This application is based upon and claims the benefit of priority from Japanese Patent Application No. 2023-112068, filed July 7, 2023.

### FIELD

Embodiments described herein relate generally to a memory device.

### BACKGROUND

A NAND flash memory capable of storing data in a nonvolatile manner is known in the art.

### BRIEF DESCRIPTION OF DRAWINGS

FIG. 1 is a block diagram showing an example of the overall configuration of a memory device according to a first embodiment.
FIG. 2 is a circuit diagram showing an example of the circuit configuration of a memory cell array included in the memory device according to the first embodiment.
FIG. 3 is a circuit diagram showing an example of the circuit configuration of a row decoder module included in the memory device according to the first embodiment.
FIG. 4 is a circuit diagram showing an example of circuit configurations of a data register and a sense amplifier module included in the memory device according to the first embodiment.
FIG. 5 is a circuit diagram showing an example of a circuit configuration of a sense amplifier unit included in a sense amplifier module provided in the memory device according to the first embodiment.
FIG. 6 is a perspective view showing an example of an appearance of the memory device according to the first embodiment.
FIG. 7 is a schematic diagram showing an example of a planar layout of bonding surfaces provided in the memory device according to the first embodiment.
FIG. 8 is a plan view showing an example of a planar layout of a memory layer included in the memory device according to the first embodiment.
FIG. 9 is a plan view showing an example of a planar layout of a memory region of a memory layer included in the memory device according to the first embodiment.
FIG. 10 is a cross-sectional view taken along line X-X of FIG. 9 and showing an example of the cross-sectional structure of the memory region of the memory layer included in the memory device according to the first embodiment.
FIG. 11 is a cross-sectional view taken along line XI-XI of FIG. 10 and showing an example of a cross-sectional structure of a memory pillar included in the memory layer of the memory device according to the first embodiment.
FIG. 12 is a plan view showing an example of a planar layout of a hookup region of a memory layer included in the memory device according to the first embodiment.
FIG. 13 is a cross-sectional view taken along line XIII-XIII of FIG. 12 and showing an example of a cross-sectional structure of a hookup region of a memory layer included in the memory device according to the first embodiment.
FIG. 14 is a cross-sectional view showing an example of the cross-sectional structure of the memory device according to the first embodiment.
FIG. 15 is a schematic diagram showing an example of threshold voltage distribution of a memory cell transistor and data allocation in the memory device according to the first embodiment.
FIG. 16 is a schematic diagram showing an example of threshold voltage distribution of a select transistor in the memory device according to the first embodiment.
FIG. 17 is a schematic diagram showing an example of threshold voltage allocation of the select transistor in the memory device according to the first embodiment.
FIG. 18 is a timing chart showing an example of even/odd bit line read operation of the memory device according to the first embodiment.
FIG. 19 is a schematic diagram showing an example of a method of selecting a bit line in the even/odd bit line read operation of the memory device according to the first embodiment.
FIG. 20 is a timing chart showing an example of even bit line read operation of the memory device according to the first embodiment.
FIG. 21 is a schematic diagram showing an example of a method of selecting a bit line in the even bit line read operation of the memory device according to the first embodiment.
FIG. 22 is a timing chart showing an example of odd bit line read operation of the memory device according to the first embodiment.
FIG. 23 is a schematic diagram showing an example of a method of selecting a bit line in the odd bit line read operation of the memory device according to the first embodiment.
FIG. 24 is a block diagram showing an example of the overall configuration of a memory device according to a second embodiment.
FIG. 25 is a circuit diagram showing an example of a circuit configuration of a memory cell array included in the memory device according to the second embodiment.
FIG. 26 is a circuit diagram showing an example of a circuit configuration of a row decoder module included in the memory device according to the second embodiment.
FIG. 27 is a circuit diagram showing an example of a circuit configuration of a sense amplifier unit included in a sense amplifier module provided in the memory device according to the second embodiment.
FIG. 28 is a perspective view showing an example of an appearance of the memory device according to the second embodiment.
FIG. 29 is a cross-sectional view showing an example of a cross-sectional structure of the memory device according to the second embodiment.
FIG. 30 is a schematic diagram showing an example of threshold voltage allocation of a select transistor in the memory device according to the second embodiment.
FIG. 31 is a timing chart showing an example of first read operation of the memory device according to the second embodiment.
FIG. 32 is a schematic diagram showing an example of a method of selecting a bit line in the first read operation of the memory device according to the second embodiment.
FIG. 33 is a schematic diagram showing an example of a method of selecting a bit line in the first read operation of the memory device according to the second embodiment.
FIG. 34 is a timing chart showing an example of second read operation of the memory device according to the second embodiment.
FIG. 35 is a timing chart showing an example of shield read operation of the memory device according to the second embodiment.
FIG. 36 is a schematic diagram showing an example of a method of selecting a bit line in the shield read operation of the memory device according to the second embodiment.
FIG. 37 is a timing chart showing an outline of write operation of the memory device according to the second embodiment.
FIG. 38 is a timing chart showing an example of program operation of the write operation of the memory device according to the second embodiment.
FIG. 39 is a schematic diagram showing an example of a method of selecting a bit line in the program operation of the write operation of the memory device according to the second embodiment.
FIG. 40 is a schematic diagram showing a further embodiment of allocation of groups of bit lines.
FIG. 41 is a cross-sectional view showing a further embodiment of the structure of the memory device.
FIG. 42 is a cross-sectional view showing an example of a detailed cross-sectional structure of a joint portion of a bonding pad.

### DETAILED DESCRIPTION

In general, according to one embodiment, a memory device includes a plurality of bit lines, a plurality of strings, a first wiring, a second wiring, a word line, and a sequencer. Each of the strings has one end coupled to the bit lines. Each of the strings includes a memory cell, a first transistor, and a second transistor coupled in series. The first wiring is coupled to the first transistor of each of the strings. The second wiring is coupled to the second transistor of each of the strings. The word line is coupled to the memory cell of each of the strings. The sequencer is configured to: in a read operation of N (N is an integer equal to or larger than 1) bytes in which the word line is selected, apply a first voltage to one of the first wiring line and the second wiring line, and apply a second voltage higher than the first voltage to the other of the first wiring line and the second wiring line; and in a read operation of 2×N bytes in which the word line is selected, apply a third voltage higher than the first voltage to each of the first wiring and the second wiring.

Hereinafter, embodiments will be described with reference to the accompanying drawings. Each embodiment illustrates a device and a method for embodying the technical idea of the invention. The drawings are schematic or conceptual. The dimensions and scales of the drawings are not necessarily the same as those of actual products. The illustration of a configuration is omitted as appropriate. The hatching added to the drawings is not necessarily related to the materials or characteristics of the structural components. The same reference numerals are added to the components having substantially the same function and configuration. Numbers etc. added to the reference symbols are referred to by the same reference symbols and are used to distinguish between similar components.

### <1> First Embodiment

A memory device 1 according to a first embodiment is a type of NAND flash memory that can store data in a nonvolatile manner. In the memory device 1 according to the first embodiment, a plurality of bit lines are classified into two groups. Then, the memory device 1 executes an operation of individually selecting two groups by using two types of select transistors included in the NAND string. Details of the first embodiment will be described below.

### <1-1> Configuration

First, a description will be given of a structure of the memory device 1 according to the first embodiment.

### <1-1-1> Overall Configuration of Memory Device 1

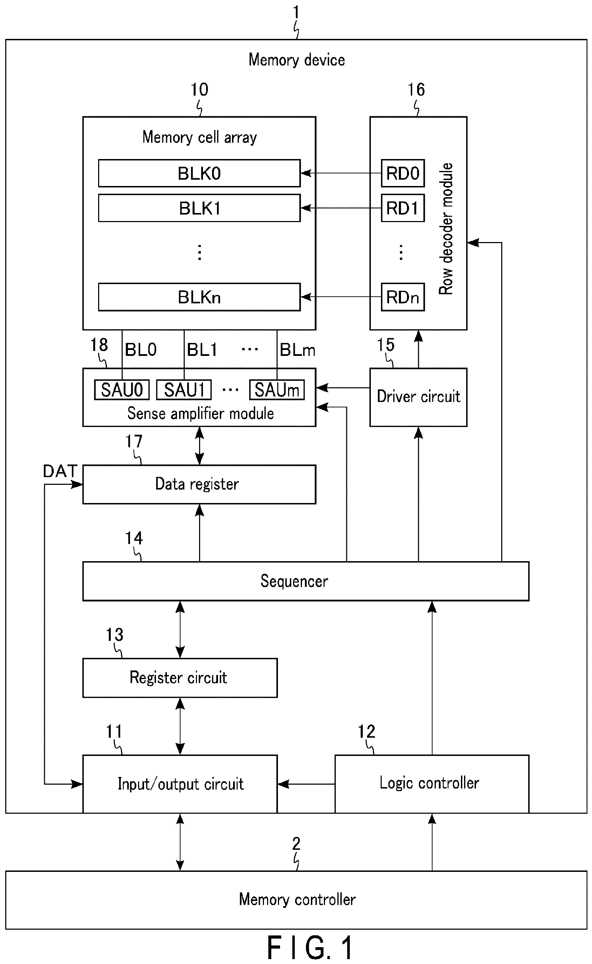

FIG. 1 is a block diagram showing an example of the overall configuration of the memory device 1 according to the first embodiment. As shown in FIG. 1, the memory device 1 is controlled by an external memory controller 2. The memory device 1 includes, for example, a memory cell array 10, an input/output circuit 11, a logic controller 12, a register circuit 13, a sequencer 14, a driver circuit 15, a row decoder module 16, a data register 17, and a sense amplifier module 18.

The memory cell array 10 is a set of memory cells. The memory cell array 10 includes a plurality of blocks BLK0 to BLKn ("n" is an integer equal to or larger than 1). For example, a block BLK corresponds to a data erase unit and includes a plurality of pages. A page corresponds to a unit in which data is read and written. The memory cell array 10 is provided with a plurality of bit lines BL0 to BLm ("m" is an integer equal to or larger than 1) and a plurality of word lines WL (not shown). Each memory cell is associated with a set consisting of a bit line BL and a word line WL. Where a plurality of memory cells are associated with a set consisting of the bit line BL and the word line WL, these memory cells are configured such that they can be individually accessed by select transistors.

The input/output circuit 11 is an interface circuit that controls transmission/reception (input/output) of input/output signals transmitted to/from the memory controller 2. The input/output signals include, for example, data DAT, status information, addresses, commands, and the like. The input/output circuit 11 can input/output the data DAT between the data register 17 and the memory controller 2. The input/output circuit 11 can output the status information transferred from the register circuit 13 to the memory controller 2. The input/output circuit 11 can output each of the address and the command, which are transferred from the memory controller 2, to the register circuit 13.

The logic controller 12 is a circuit that controls each of the input/output circuit 11 and the sequencer 14, based on a control signal input from the memory controller 2. The logic controller 12 commands the input/output circuit 11 to input a signal from the memory controller 2 or output a signal to the memory controller 2. In addition, the logic controller 12 notifies the input/output circuit 11 of the type (for example, any one of the data DAT, the command, and the address) of the input/output signal received by the input/output circuit 11.

The register circuit 13 is a circuit that temporarily stores a status, an address, and a command. The status is information indicating an operation state of the memory device 1. The status is updated under control of the sequencer 14 and transferred to the memory controller 2 via the input/output circuit 11. The address can include a block address, a page address, a column address, etc. The command includes a command related to various operations of the memory device 1.

The sequencer 14 is a controller that controls the overall operation of the memory device 1. The sequencer 14 executes a read operation, a write operation, an erase operation, and the like, based on the command and the address stored in the register circuit 13.

The driver circuit 15 is a circuit that generates voltages used in a read operation, a write operation, an erase operation, and the like. The driver circuit 15 supplies the generated voltages to the row decoder module 16, the sense amplifier module 18, and the like.

The row decoder module 16 is a circuit used for selecting a block BLK to be operated such as a read operation and transferring a voltage to such a wiring as a word line WL. The row decoder module 16 includes a plurality of row decoders RD0 to RDn. The row decoders RD0 to RDn are associated with the blocks BLK0 to BLKn, respectively. The detailed configuration of the row decoders RD will be described later.

The data register 17 is a circuit that temporarily stores data DAT. The data register 17 can input/output data DAT between the input/output circuit 11 and the sense amplifier module 18. The data register 17 may be referred to as a cache memory.

The sense amplifier module 18 is a circuit used for transferring a voltage to each bit line BL and for reading data. The sense amplifier module 18 includes a plurality of sense amplifier units SAUO to SAUm. The sense amplifier units SAUO to SAUm are associated with a plurality of bit lines BL0 to BLm, respectively. A detailed configuration of the sense amplifier unit SAU will be described later.

The combination of the memory device 1 and the memory controller 2 may constitute one semiconductor device. Examples of such a semiconductor device include a memory card such as an SD^{™} card, and an SSD (solid state drive). A set consisting of the memory cell array 10, the row decoder module 16 and the sense amplifier module 18 is referred to as "plane", for example. The memory device 1 may include a plurality of planes.

### <1-1-2> Circuit Configuration of Memory Device 1

Hereinafter, a description will be given of the circuit configuration of the memory device 1 according to the first embodiment. In the descriptions below, a MOS transistor having a high breakdown voltage will be referred to as an "HV (High-Voltage) transistor". A MOS transistor having a breakdown voltage lower than that of the HV transistor will be referred to as an "LV (Low-Voltage) transistor". The LV transistor includes, for example, a gate insulating film thinner than that of the HV transistor and can operate faster than the HV transistor.

### (1: Circuit Configuration of Memory Cell Array 10)

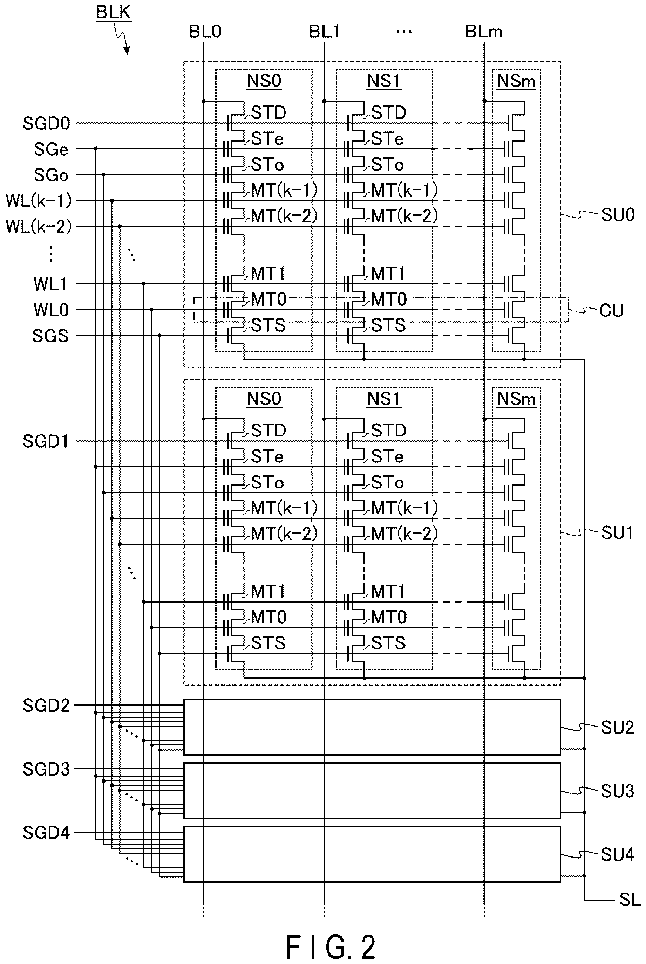

FIG. 2 is a circuit diagram showing an example of the circuit configuration of the memory cell array 10 included in the memory device 1 according to the first embodiment. FIG. 2 shows one block BLK that is among a plurality of blocks BLK included in the memory cell array 10. As shown in FIG. 2, the select gate lines SGD0 to SGD4, SGe, and SGo, the word lines WL0 to WL (k-1) (k is an integer of 2 or more), the select gate line SGS, the bit lines BLO to BLm, and the source line SL are coupled to the block BLK, respectively. The select gate lines SGD0 to SGD4, the select gate lines SGe and SGo, the word lines WL0 to WL (k-1), and the select gate line SGS are provided for each block BLK. Each of the bit lines BLO to BLm and the source line SL can be shared by a plurality of blocks BLK.

The block BLK includes, for example, five string units SUO to SU4. Each string unit SU includes NAND strings NS0 to NSm. The NAND strings NSO to NSm are associated with the bit lines BLO to BLm, respectively. Each NAND string NS is coupled between the associated bit line BL and the source line SL. Each bit line BL is shared by the NAND strings NS which are included in the plurality of blocks BLK and to which the same column address is assigned.

Each NAND string NS includes, for example, a select transistor STD, select transistors STe and STo, k number of memory cell transistors MTO to MT (k-1), and a select transistor STS. In each NAND string NS, the select transistors STD, STe, and STo, the memory cell transistors MT (k-1) to MTO, and the select transistor STS are coupled in series in this order. Then, in each NAND string NS, the drain of the select transistor STD is coupled to the associated bit line BL, and the source of the select transistor STS is coupled to the source line SL.

Each memory cell transistor MT is a memory cell having a control gate and a charge storage layer, and holds (stores) data in a nonvolatile manner. The memory cell transistor MT may be a charge trap type memory cell or a floating gate type memory cell. The select transistors STD and STS are used to select a string unit SU. Each of the select transistors STe and STo may have a structure same as that of the memory cell transistor MT, and may be referred to as a memory cell. The select transistors STe and STo are used to select a group of the bit lines BL. In the first embodiment, a case where an even bit line group including the even bit line BLe(BL0, BL2, BL4,...) and an odd bit line group including the odd bit line BLo(BL1, BL3, BL5,...) are configured to be individually selectable among the plurality of bit lines BL0 to BLm will be described as an example.

The select gate lines SGD0 to SGD4 are associated with string units SUO to SU4, respectively. Each select gate line SGD is coupled to each of the gates of a plurality of select transistors STD included in the associated string unit SU. The select gate line SGe is coupled to each of the gates of a plurality of select transistors STe included in the block BLK. The select gate line SGo is coupled to each of the gates of a plurality of select transistors STo included in the block BLK. The select gate line SGS is coupled to each of the gates of a plurality of select transistors STS included in the block BLK. The word lines WL0 to WL(k-1) are respectively coupled to the control gates of the memory cell transistors MTO to MT(k-1) included in the block BLK.

A set of memory cell transistors MT included in the same string unit SU and coupled to the same word line WL is referred to as "cell unit CU", for example. For example, the storage capacity which the cell unit CU has when each memory cell transistor MT stores 1-bit data is defined as "1 page data". The 1 page data is, for example, 16KB (kilobytes). The size of the 1-page data can be appropriately changed according to the design of the memory device 1. In addition, a cell unit CU can store two or more pages of data according to the number of bits of data stored in each memory cell transistor MT.

It should be noted that the memory cell array 10 may have other circuit configurations. The select transistors STe and STo may not be adjacent to each other, may be arranged on the select gate line SGS side, or may be arranged in an intermediate portion of the NAND string NS. For the select transistors STe and STo, for example, the number of string units SU included in the block BLK, and the numbers of memory cell transistors MT and select transistors STD, STS, STe, and STo included in the NAND string NS can be designed to be any number. In the first embodiment, a case where the number of memory cell transistors MT included in the NAND string NS is six will be described as an example.

### (2: Circuit Configuration of Row Decoder Module 16)

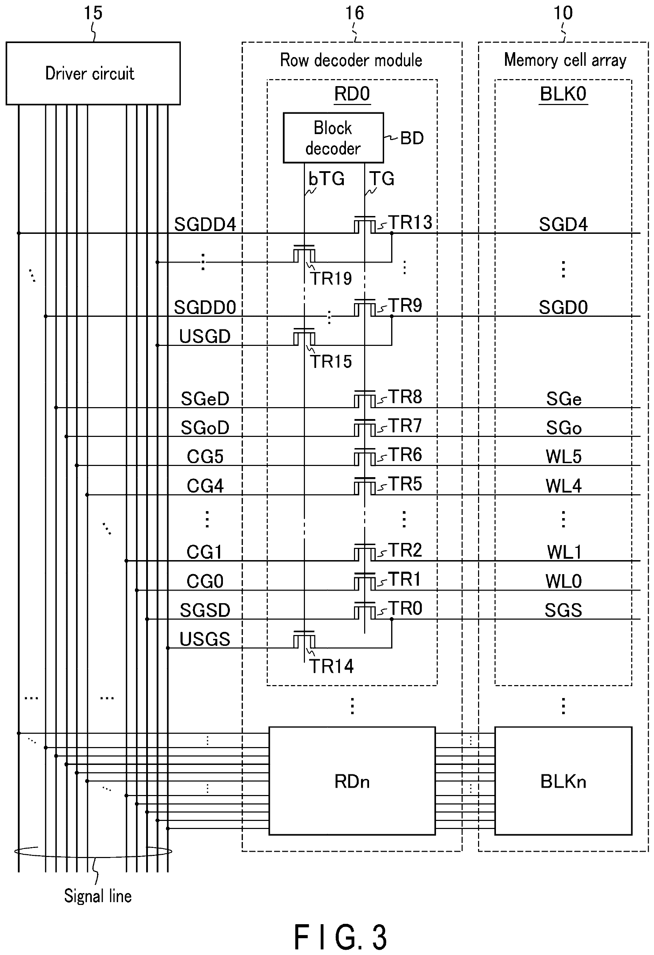

FIG. 3 is a circuit diagram showing an example of the circuit configuration of a row decoder module 16 included in the memory device 1 according to the first embodiment. FIG. 3 shows how the driver circuit 15, the memory cell array 10 and the row decoder module 16 are coupled to each other, and also shows a detailed circuit configuration of one row decoder RD0 included in the row decoder module 16. The circuit configurations of the row decoders RD other than the row decoder RD0 are the same as the circuit configuration of the row decoder RD0, except the associated block BLK. As shown in FIG. 3, each row decoder RD is coupled to signal lines CGO to CG5, SGDDO to SGDD4, SGSD, SGeD, SGoD, USGD, and USGS that are coupled to the driver circuit 15. Each row decoder RD is also coupled to the word lines WL0 to WL5 of the associated block BLK, and to the select gate lines SGD0 to SGD4, SGe, SGo, and SGS.

The row decoder RD0 includes, for example, transistors TR0 to TR19, transfer gate lines TG and bTG, and a block decoder BD. Each of the transistors TR0 to TR19 is an n-type HV transistor. The transfer gate line TG is coupled to each of the gates of the transistors TR0 to TR13. The transfer gate line bTG is coupled to each of the gates of the transistors TR14 to TR19. The drains of the transistors TR0 to TR13 are coupled to signal lines SGSD, CGO to CG5, SGoD, SGeD, and SGDDO to SGDD4, respectively. The sources of the transistors TR0 to TR13 are coupled to the select gate line SGS, the word lines WL0 to WL5, and the select gate lines SGo, SGe, and SGD0 to SGD4 of the block BLK0, respectively. The drain and source of the transistor TR14 are respectively coupled to the signal line USGS and the select gate line SGS of the block BLK0. The drains of the transistors TR15 to TR19 are coupled to the signal line USGD. The sources of the transistors TR15 to TR19 are coupled to the select gate lines SGD0 to SGD4 of the block BLK0, respectively.

The block decoder BD is a circuit that decodes a block address. The block decoder BD applies one of an "H" level voltage and an "L" level voltage to the transfer gate line TG and applies the other one of the "H" level voltage and the "L" level voltage to the transfer gate line bTG, based on the decoding result of the block address. Specifically, the block decoder BD of to the selected block BLK applies "H" level and "L" level voltages to the transfer gate lines TG and bTG, respectively. The block decoder BD of a non-selected block BLK applies "L" level and "H" level voltages to the transfer gate lines TG and bTG, respectively. As a result, the voltages of the signal lines CG0 to CG5, SGoD, and SGeD are transferred to the word lines WL0 to WL5 and the select gate lines SGo and SGe of the selected block BLK, respectively, the voltages of the signal lines SGDDO to SGDD4 and SGSD are transferred to the select gate lines SGD0 to SGD4 and SGS of the selected block BLK, respectively, and the voltages of the signal lines USGD and USGS are transferred to the select gate lines SGD and SGS of the non-selected blocks BLK, respectively.

The row decoder module 16 may have other circuit configurations. For example, the number of transistors TR included in the row decoder module 16 can be appropriately changed in accordance with the number of wirings of each block BLK. Since the signal line CG is shared by a plurality of blocks BLK, it may be referred to as a "global word line". Since the word line WL is provided for each block, it may be referred to as a "local word line". Since each of the signal lines SGDD, SGeD, SGoD, and SGSD is shared by a plurality of blocks BLK, it may be referred to as a "global transfer gate line". Since each of the select gate lines SGD, SGe, SGo, and SGS is provided for each block, it may be referred to as a "local transfer gate line".

### (3: Circuit Configuration of Sense Amplifier Module 18 and Data Register 17)

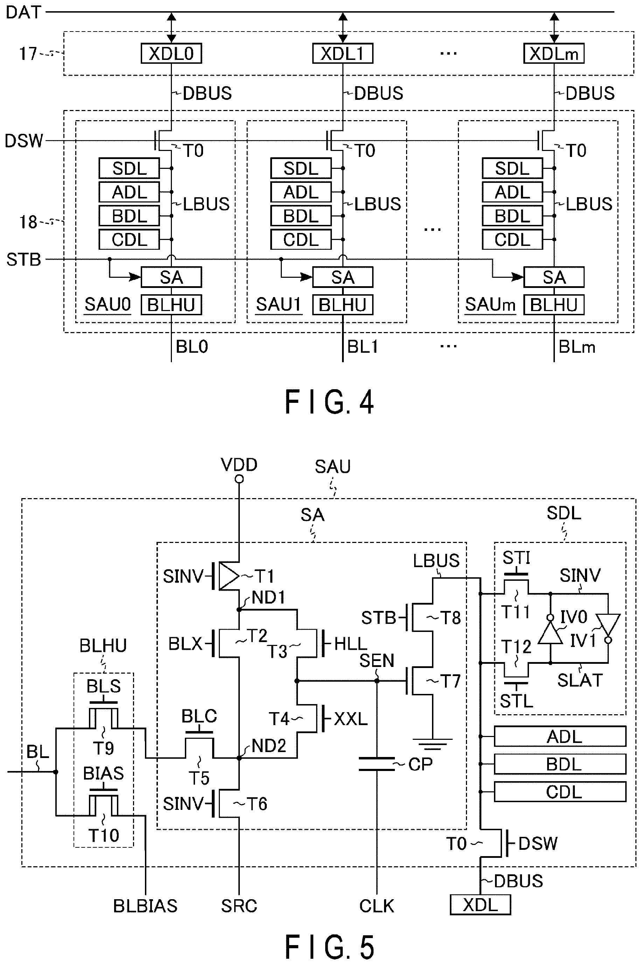

FIG. 4 is a circuit diagram showing an example of circuit configurations of a sense amplifier module 18 and a data register 17 included in the memory device 1 according to the first embodiment. As shown in FIG. 4, each sense amplifier unit SAU includes, for example, a bit line connection unit BLHU, a sense amplifier unit SA, buses DBUS and LBUS, latch circuits SDL, ADL, BDL and CDL, and a transistor T0. The data register 17 includes, for example, a plurality of latch circuits XDLO to XDLm. The latch circuits XDLO to XDLm are associated with a plurality of sense amplifier units SAUO to SAUm, respectively. Each of the latch circuits XDLO to XDLm is coupled to the associated sense amplifier unit SAU via the bus DBUS.

The bit line connection unit BLHU is, for example, a protection circuit for preventing a high voltage, which is to be applied to the channel of the NAND string NS in an erase operation, from being applied to the sense amplifier unit SA. The bit line connection unit BLHU may be configured to be able to apply a predetermined voltage to the unselected bit lines BL.

The sense amplifier unit SA is a circuit used for determining data, based on the voltage of the bit line BL, and for applying a voltage to the bit line BL. Each sense amplifier section SA is coupled to the associated bit line BL via the bit line connection unit BLHU. Where the control signal STB is asserted during the read operation, the sense amplifier unit SA determines whether the data read from the selected memory cell transistor MT is "0" data or "1" data, based on the voltage of the associated bit line BL.

Each of the latch circuits SDL, ADL, BDL and CDL is a circuit capable of temporarily holding data. The latch circuits SDL, ADL, BDL and CDL, and the sense amplifier unit SA are configured such that they can transmit and receive data via the bus LBUS.

The transistor TO of each sense amplifier unit SAU controls transfer of signals between associated buses DBUS and LBUS. One end of the transistor TO of each sense amplifier unit SAU is coupled to the associated bus DBUS. The other end of the transistor T0 of each sense amplifier unit SAU is coupled to the associated bus LBUS. A control signal DSW is input to the gate of the transistor T0 of each sense amplifier unit. The control signal DSW is generated by the sequencer 14, for example.

Each latch circuit XDL is a circuit capable of temporarily holding data. Each latch circuit XDL is configured such that it can transmit and receive data to and from the associated sense amplifier unit SAU via the bus DBUS. Each latch circuit XDL is used to input/output data DAT between the sense amplifier module 18 and the input/output circuit 11. Each latch circuit XDL may be shared by the plurality of sense amplifier units SAU.

### (4: Circuit Configuration of Sense Amplifier Unit SAU)

FIG. 5 is a circuit diagram showing an example of a circuit configuration of the sense amplifier unit SAU included in the sense amplifier module 18 of the memory device 1 according to the first embodiment. As shown in FIG. 5, the sense amplifier unit SA includes, for example, transistors T1 to T8, a capacitor CP, and nodes ND1, ND2, SEN and SRC. The bit line connection unit BLHU includes, for example, the transistors T9 and T10 and the node BLBIAS. The latch circuit SDL includes, for example, inverters IVO and IV1, transistors T11 and T12, and nodes SINV and SLAT. The transistor T1 is a p-type LV transistor. Each of the transistors T2 to T8, T11 and T12 is an n-type LV transistor. Each of the transistors T9 to T10 is an n-type HV transistor.

The source, drain, and gate of the transistor T1 are coupled to a power supply line, the node ND1, and the node SINV, respectively. A power supply voltage VDD, for example, is applied to the power supply line. The drain and source of the transistor T2 are coupled to the nodes ND1 and ND2, respectively. A control signal BLX is input to the gate of the transistor T2. The drain and source of the transistor T3 are coupled to the nodes ND1 and SEN, respectively. A control signal HLL is input to the gate of the transistor T3. The drain and source of the transistor T4 are coupled to the nodes SEN and ND2, respectively. A control signal XXL is input to the gate of the transistor T4. The drain of the transistor T5 is coupled to the node ND2. A control signal BLC is input to the gate of the transistor T5. The drain, source, and gate of the transistor T6 are coupled to the nodes ND2, SRC and SINV, respectively. For example, a ground voltage VSS is applied to the node SRC. The source and gate of the transistor T7 are coupled to a ground node and the node SEN, respectively. A ground voltage VSS, for example, is applied to the ground node. The drain and source of the transistor T8 are coupled to the bus LBUS and the drain of the transistor T7, respectively. A control signal STB is input to the gate of the transistor T8. One electrode of the capacitor CP is coupled to the node SEN. The other electrode of the capacitor CP is supplied with a clock signal CLK.

The drain and source of the transistor T9 are respectively coupled to the source of the transistor T8 and the associated bit line BL. A control signal BLS is input to the gate of the transistor T9. The drain and source of the transistor T10 are respectively coupled to the node BLBIAS and the associated bit line BL. A control signal BIAS is input to the gate of the transistor T10.

One end and the other end of the transistor T11 are coupled to the bus LBUS and the node SINV, respectively. A control signal STI is input to the gate of the transistor T11. One end and the other end of the transistor T12 are coupled to the bus LBUS and the node SLAT, respectively. A control signal STL is input to the gate of the transistor T12. The input node and output node of the inverter IVO are coupled to the nodes SLAT and SINV, respectively. The input node and output node of the inverter IV1 are coupled to the nodes SINV and SLAT, respectively. The latch circuit SDL holds data at the node SLAT, and holds the inverted data of the data of the node SLAT at the node SINV. Each of the latch circuits ADL, BDL, and CDL has a configuration same as that of the latch circuit SDL, except that control signals supplied to a data holding node, an inverted data holding node, and the transistors T11 and T12 are prepared independently of the latch circuit SDL.

It should be noted that each of the control signals BLX, HLL, XXL, BLC, STB, BLS, BIAS, STI and STL and the clock signal CLK is generated by the sequencer 14, for example. The sense amplifier module 18 may have other circuit configurations. For example, the number of latch circuits included in each sense amplifier unit SAU can be appropriately changed. The sense amplifier unit SAU may have an arithmetic circuit capable of executing a simple logic operation. In a read operation of each page, the sense amplifier module 18 can determine (finalize) the data stored in the memory cell transistor MT by appropriately executing arithmetic processing using the latch circuits.

Hereinafter, the sense amplifier unit SAU coupled to the even bit line BLe is referred to as a "sense amplifier unit SAUe". The sense amplifier unit SAU coupled to the odd bit line BLo is referred to as a "sense amplifier unit SAUo". In the first embodiment, the sequencer 14 is configured to be able to individually control a control signal BLC used to control the sense amplifier unit SAUe and a control signal BLC used to control the sense amplifier unit SAUo. Hereinafter, the control signal BLC used to control the sense amplifier unit SAUe is referred to as a "control signal BLCe". The control signal BLC used to control the sense amplifier unit SAUo is referred to as a "control signal BLCo".

### <1-1-3> Structure of Memory Device 1

Hereinafter, a description will be given of the structure of the memory device 1 according to the first embodiment. In the drawings referenced below, a three-dimensional Cartesian coordinate system is used. The X direction corresponds to the direction in which the word line WL extends. The Y direction corresponds to the direction in which the bit line BL extends. The Z direction corresponds to the vertical direction with respect to the surface of a reference substrate. The XZ plane corresponds to a plane parallel to each of the X and Z directions. The "up" or "down" in the present specification is defined based on the Z direction, and the direction away from the reference substrate is defined as a positive direction (upward). As a reference substrate, for example, the substrate depicted at the lowermost position in the drawings is used. The front surface of the substrate corresponds to the surface on which transistors (CMOS circuits) are formed. The back surface of the substrate corresponds to the surface opposite to the front surface.

### (1: Appearance of Memory Device 1)

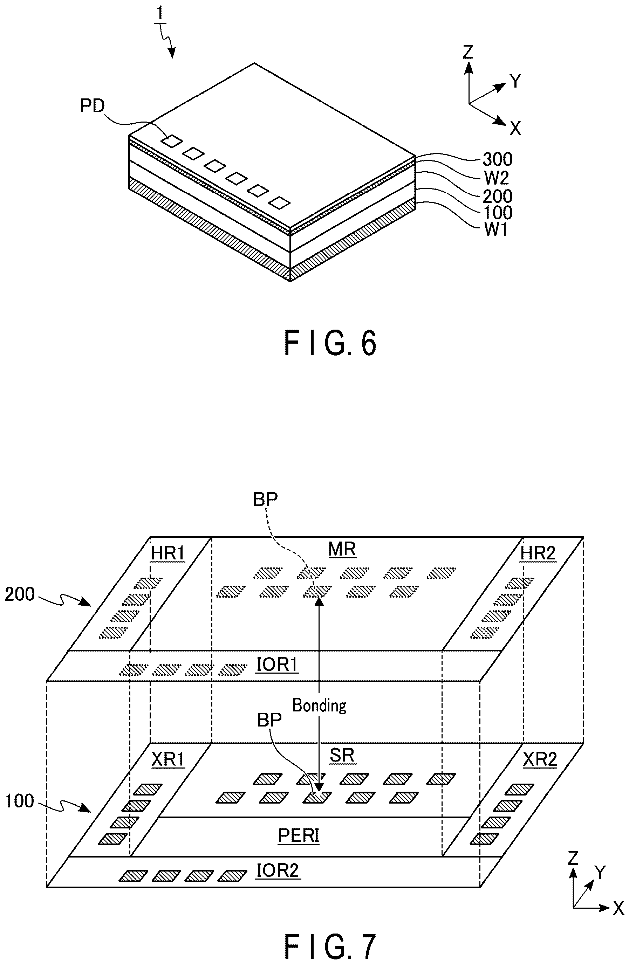

FIG. 6 is a perspective view showing an example of an appearance of the memory device 1 according to the first embodiment. As shown in FIG. 6, the memory device 1 has a structure in which, for example, a first substrate W1, a CMOS layer 100, a memory layer 200, a second substrate W2, and a wiring layer 300 are stacked in this order from below.

The CMOS layer 100 includes CMOS circuits formed using the first substrate W1. The CMOS layer 100 includes, for example, an input/output circuit 11, a logic controller 12, a register circuit 13, a sequencer 14, a driver circuit 15, a row decoder module 16, a data register 17, and a sense amplifier module 18. The memory layer 200 includes a memory cell array 10 formed using the second substrate W2. The wiring layer 300 includes, for example, a plurality of pads PD. The plurality of pads PD are used for coupling the memory device 1 and the memory controller 2, and are exposed on the surface of the memory device 1.

Each of the first substrate W1 and the second substrate W2 is a silicon substrate. The first substrate W1 includes an impurity diffusion region formed in accordance with the circuit design of the memory device 1. The memory device 1 has a bonding surface between CMOS layer 100 and the memory layer 200. The bonding surface corresponds to the boundary portion of the two bonded substrates. In this example, the surface of the CMOS layer 100 on the first substrate W1 and the surface of the memory layer 200 on the second substrate W2 are bonded by the bonding process of the first substrate W1 and the second substrate W2. The second substrate W2 may be removed after the first substrate W1 and the second substrate W2 are bonded. In this case, the memory device 1 does not include the second substrate W2.

### (2: Planar Layout of Bonding Surface)

FIG. 7 is a schematic diagram showing an example of a planar layout of a bonding surface provided in the memory device 1 according to the first embodiment. FIG. 7 shows a planar layout of the bonding surface between the CMOS layer 100 and the memory layer 200. As shown in FIG. 7, the memory layer 200 includes, for example, memory region MR, a hookup regions HR1 and HR2, and an input/output region IOR1. The CMOS layer 100 includes, for example, a sense amplifier region SR, a peripheral circuit region PERI, transfer regions XR1 and XR2, and an input/output region IOR2.

The memory region MR is used for data storage and include a plurality of NAND strings NS. The hookup regions HR1 and HR2 sandwich the memory region MR in the X direction. The hookup region HR is a region used for coupling between the stacked wirings provided in the memory region MR and the transistors provided in the transfer region XR facing in the Z direction. The input/output region IOR1 is adjacent to each of the memory region MR and the hookup regions HR1 and HR2 in the Y direction. The input/output region TOR1 includes a circuit related to the input/output circuit 11.

The sense amplifier region SR includes the sense amplifier module 18. The peripheral circuit region PERI includes a sequencer 14, etc. The sense amplifier region SR and the peripheral circuit region PERI are arranged adjacent to each other in the Y direction and overlap the memory region MR in the Z direction. The transfer regions XR1 and XR2 include a row decoder module 16. The transfer regions XR1 and XR2 sandwich a set of the sense amplifier region SR and the peripheral circuit region PERI in the X direction, and overlap the hookup regions HR1 and HR2 respectively in the Z direction. The input/output region IOR2 includes the input/output circuit 11, etc. The input/output region IOR2 overlaps the input/output region IOR1 in the Z direction.

The memory layer 200 includes a plurality of bonding pads BP in contact with the bonding surface. Similarly, the CMOS layer 100 includes a plurality of bonding pads BP in contact with the bonding surface. The plurality of bonding pads BP provided on the bonding surface of the memory layer 200 is arranged to face the plurality of bonding pads BP provided on the bonding surface of the CMOS layer 100. A set of two bonding pads BP arranged to face each other between the memory layer 200 and the CMOS layer 100 is bonded by bonding processing ("bonding " in FIG. 7). As a result, the two bonding pads BP arranged to face each other are electrically coupled.

It should be noted that the planar layout of the bonding surface included in the memory device 1 may be another layout. For example, it suffices that at least one hookup region HR is provided. The memory device 1 may include a plurality of memory regions MR. The arrangement of the memory region MR, the hookup region HR, the sense amplifier region SR, the peripheral circuit region PERI, the transfer region XR, and the input/output region IOR can be appropriately changed. It should be noted that each of the bonding pads BP may be referred to as a "joint metal".

### (3: Planar layout of Memory Layer 200)

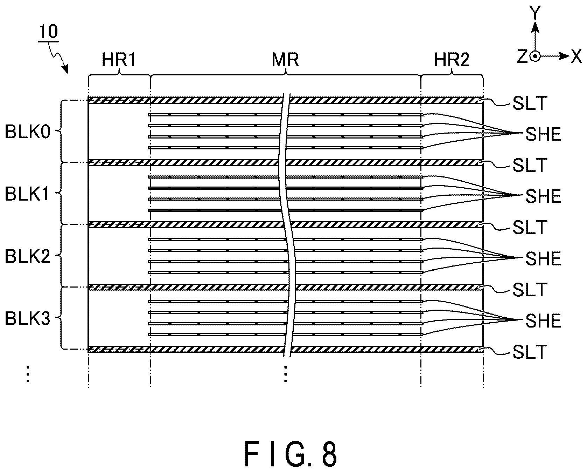

FIG. 8 is a plan view showing an example of a planar layout of the memory layer 200 included in the memory device according to the first embodiment. FIG. 8 shows regions corresponding to the four blocks BLK0 to BLK3 included in the memory cell array 10. As shown in FIG. 8, the memory cell array 10 includes, for example, a plurality of slits SLT and a plurality of slits SHE.

Each slit SLT includes a portion extending along the X direction, and crosses the hookup region HR1, the memory region MR, and the hookup region HR2 along the X direction. The plurality of slits SLT are arranged in the Y direction. Each slit SLT has, for example, a structure in which an insulator is embedded. Each slit SLT divides the wirings (e.g., word lines WL0 to WL5 and select gate lines SGD, SGe, SGo, and SGS), which are adjacent to each other via the slit SLT. In the memory cell array 10, each of the regions partitioned by the slits SLT corresponds to one block BLK.

Each slit SHE includes a portion extending along the X direction and crosses the memory region MR along the X direction. The plurality of slits SHE are arranged in the Y direction. In this example, four slits SHE are arranged between two slits SLT that are adjacent to each other in the Y direction. Each slit SHE has, for example, a structure in which an insulator is embedded. Each slit SHE divides wirings (at least the select gate line SGD), which are adjacent to each other with the slit SHE interposed. In the memory cell array 10, each of the regions partitioned by the slits SLT and SHE corresponds to one string unit SU.

It should be noted that the planar layout of the memory layer 200 may be another layout. For example, the number of slits SHE arranged between two adjacent slits SLT can be designed to be any number. The number of string units SU included in each block BLK can be changed based on the number of slits SHE arranged between two adjacent slits SLT.

### (4: Planar Layout of Memory Region MR)

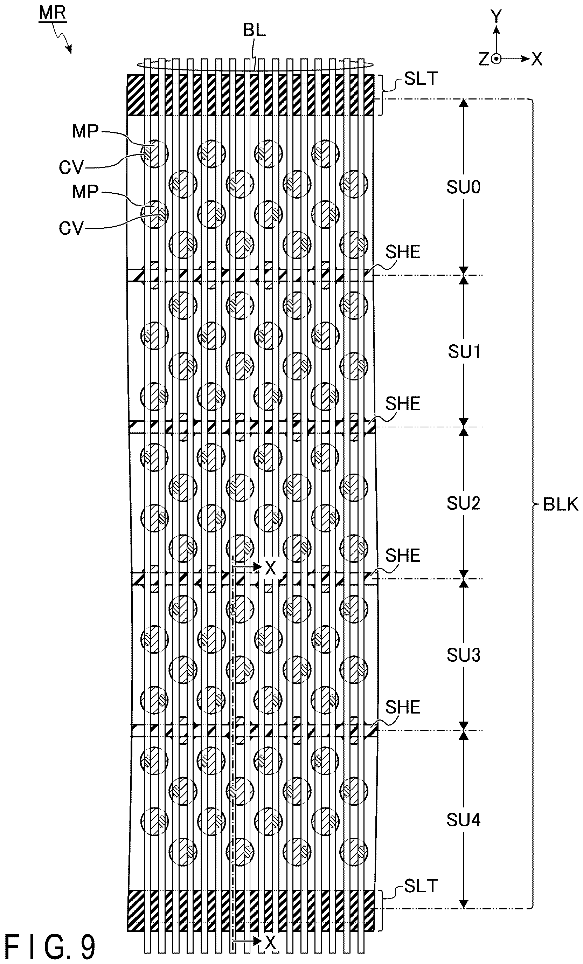

FIG. 9 is a plan view showing an example of a planar layout of the memory region MR of the memory layer 200 included in the memory device 1 according to the first embodiment. FIG. 9 shows a region including one block BLK (string units SU0 to SU4). As shown in FIG. 9, in the memory region MR, the memory device 1 includes, for example, a plurality of memory pillars MP, a plurality of contacts CV, and a plurality of bit lines BL.

Each memory pillar MP functions as one NAND string NS. In the region between two adjacent slits SLT, the plurality of memory pillars MP are arranged, for example, in 24 rows and in a staggered fashion. For example, slits SHE are arranged such that one overlaps the memory pillars MP in the 5th row from the upper side of the drawing sheet, one overlaps the memory pillars MP in the 10th row, one overlaps the memory pillars MP in the 15th row, and one overlaps the memory pillars MP in the 20th row.

Each bit line BL includes a portion extending in the Y direction. The plurality of bit lines BL are arranged in the X direction. Each bit line BL is arranged such that it overlaps at least one memory pillar MP in each string unit SU. In this example, the bit lines BL are arranged such that two bit lines overlap one memory pillar MP. The memory pillar MP is electrically coupled to one of the plurality of overlapping bit lines BL via the contacts CV. It should be noted that the contact CV between the memory pillar MP in contact with two different select gate lines SGD and the bit line BL may be omitted.

It should be noted that the planar layout of the memory region MR may be another layout. For example, the numbers of memory pillars MP and slits SHE arranged between two adjacent slits SLT, and how they are arranged can be changed as appropriate. The number of bit lines BL overlapping each memory pillar MP can be designed to be any number.

### (5. Cross-Sectional Structure of Memory Region MR)

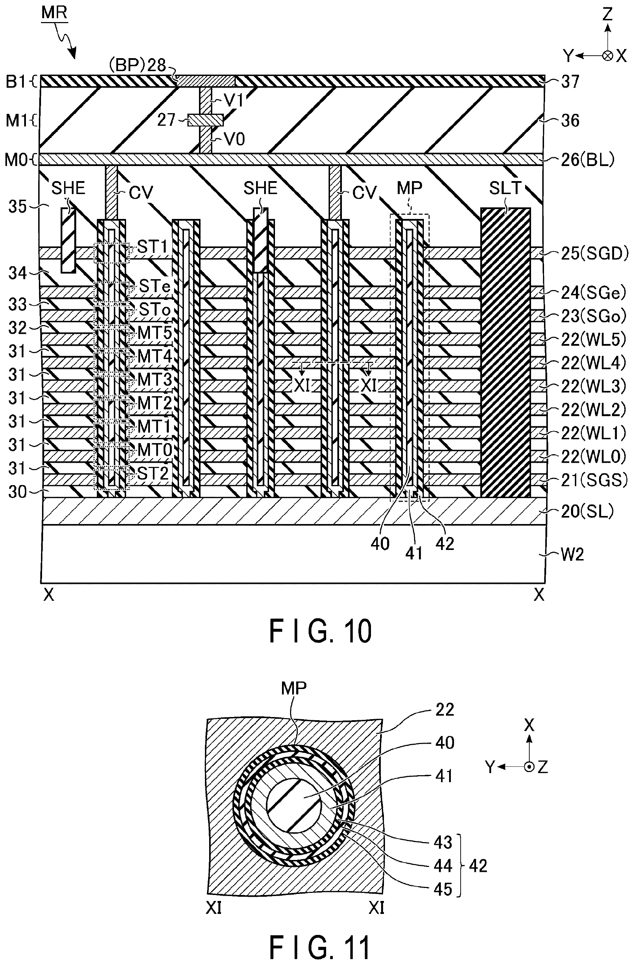

FIG. 10 is a cross-sectional view taken along line X-X of FIG. 9 and showing an example of the cross-sectional structure of the memory region MR of the memory layer 200 included in the memory device 1 according to the first embodiment. FIG. 10 shows an example of how the structure of the memory cell array 10 formed on the second substrate W2 is before bonding to the first substrate W1, and shows coordinate axes using the second substrate W2 as a reference. As shown in FIG. 10, memory region MR includes, for example, conductive layers 20 to 28, insulating layers 30 to 37, and contacts V0 and V1.

The conductive layer 20 is provided on the second substrate W2. The insulating layer 30 and the conductive layer 21 are provided in this order on the conductive layer 20. The insulating layer 31 and the conductive layer 22 are alternately provided on the conductive layer 21. On the uppermost conductive layer 22, an insulating layer 32, a conductive layer 23, an insulating layer 33, a conductive layer 24, an insulating layer 34, a conductive layer 25, an insulating layer 35, and a conductive layer 26 are provided in this order. The contact V0 is provided on the conductive layer 26. The conductive layer 27 is provided on the contact V0. The contact V1 is provided on the conductive layer 27. The conductive layer 28 is provided on the contact V1. The contact V0, the conductive layer 27 and the contact V1 are covered with the insulating layer 36. The insulating layer 36 may be composed of a plurality of insulating layers. The insulating layer 37 is provided on the insulating layer 36. In the descriptions below, the layers that are provided at the heights of the conductive layers 26 and 27 will be referred to as wiring layers MO and M1, respectively. The layer having the height where the conductive layer 28 and the insulating layer 37 are provided will be referred to as a "bonding layer B1".

Each of the conductive layers 21, 22, 23, 24, and 25 is formed, for example, as a plate spreading along the XY plane. The conductive layer 26 is formed, for example, as a line extending in the Y direction. The conductive layers 20, 21, 23, 24 and 25 are used as a source line SL, select gate lines SGS, SGo, SGe, and SGD, respectively. The plurality of conductive layers 22 are respectively used as word lines WL0 to WL5 in this order from below. The conductive layer 26 is used as a bit line BL. The contacts V0 and V1 are provided as having a columnar shape. The conductive layers 26 and 27 are coupled to each other via the contact V0. The conductive layer 27 and the conductive layer 28 are coupled to each other via the contact V1. The conductive layer 28 corresponds to the bonding pad BP. The conductive layer 28 contains, for example, copper.

The slit SLT includes a plate-like portion spreading along the XZ plane, and divides the insulating layers 30 to 34 and the conductive layers 21 to 25. Each memory pillar MP is provided to extend in the Z direction and penetrates the insulating layers 30 to 34 and the conductive layers 21 to 25. Each memory pillar MP includes, for example, a core member 40, a semiconductor layer 41, and a stacked film 42. The core member 40 is an insulator extending along the Z direction. The semiconductor layer 41 covers the core member 40. A lower portion of the semiconductor layer 41 is in contact with the conductive layer 20. The stacked film 42 covers the side surface of the semiconductor layer 41. A contact CV is provided on the semiconductor layer 41. The semiconductor layer 41 and the conductive layer 26 are coupled to each other via the contact CV.

The portion where the memory pillar MP and the conductive layer 21 intersect functions as a select transistor STS. The portion where the memory pillar MP and the conductive layer 22 intersect functions as a memory cell transistor MT. The portion where the memory pillar MP and the conductive layer 23 intersect functions as a select transistor STo. The portion where the memory pillar MP and the conductive layer 24 intersect functions as a select transistor STe. The portion where the memory pillar MP and the conductive layer 25 intersect functions as a select transistor STD. In the memory pillar MP, the semiconductor layer 41 is used as a channel (current path) of the memory cell transistors MTO to MT5 and the select transistors STD, STe, STo, and STS.

### (6: Cross-Sectional Structure of Memory Pillar MP)

FIG. 11 is a cross-sectional view taken along line XI-XI of FIG. 10 and showing an example of a cross-sectional structure of a memory pillar MP included in the memory layer 200 of the memory device 1 according to the first embodiment. FIG. 11 shows a cross section that includes the memory pillar MP and the conductive layer 22 and that is parallel to the surface of the source line SL. As shown in FIG. 11, the stacked film 42 includes, for example, a tunnel insulating film 43, an insulating film 44, and a block insulating film 45. The tunnel insulating film 43 surrounds the side surface of the semiconductor layer 41. The insulating film 44 covers the side surface of the tunnel insulating film 43. The block insulating film 45 surrounds the side surface of the insulating film 44. The conductive layer 22 surrounds the side surface of the block insulating film 45. Each of the tunnel insulating film 43 and the block insulating film 45 contains silicon oxide, for example. The insulating film 44 is used as a charge storage layer of the memory cell transistor MT. The insulating film 44 contains, for example, silicon nitride.

### (7: Planar Layout of Hookup Region HR1)

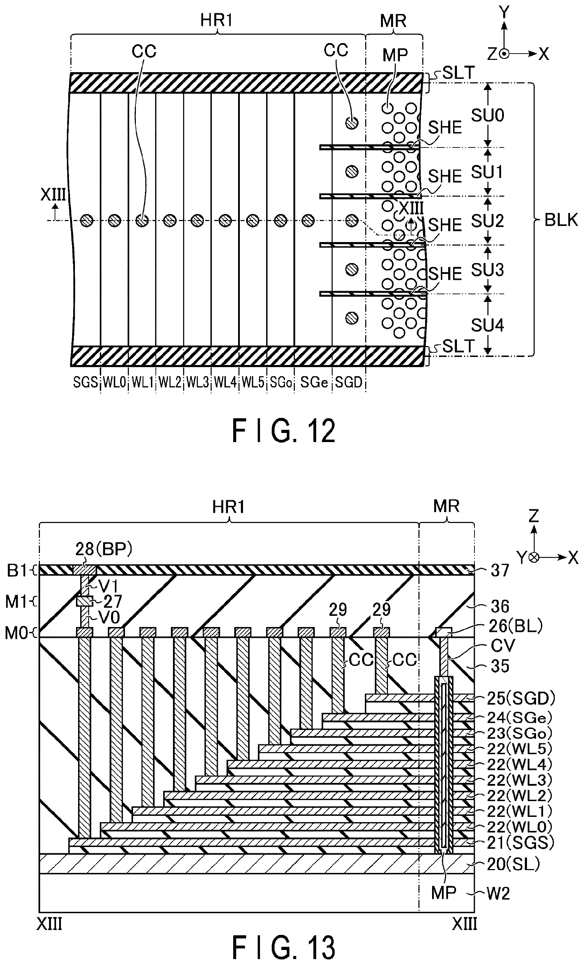

FIG. 12 is a plan view showing an example of the planar layout of the hookup region HR1 of the memory layer 200 included in the memory device 1 according to the first embodiment. FIG. 12 shows a region including the hookup region HR1 and a part of the memory region MR and corresponding to the even block BLKe(BLKO, BLK2,...) among the plurality of blocks BLK. As shown in FIG. 12, in the hookup region HR1, the end portion of each of the select gate line SGS, the word lines WL0 to WL5, and the select gate lines SGo, SGe, and SGD of the block BLKe includes a terrace portion.

The terrace portion corresponds to that portion of the stacked wiring that does not overlap a wiring layer (conductive layer) located above. The structure formed by a plurality of terraces is similar to steps, terraces, rimstones, etc. In this example, a staircase structure having steps in the X direction is formed by each end portion of the select gate line SGS, the word lines WL0 to WL5, and the select gate lines SGo, SGe, and SGD.

The memory layer 200 includes a plurality of contacts CC in the hookup region HR. The contacts CC are conductors used for coupling between the row decoder module 16 and stacked wirings. A plurality of contacts CC associated with the even block BLKe are coupled to each of the select gate lines SGS, SGo, SGe, and SGD provided in the hookup region HR1 and each of the terrace portions of the word lines WL0 to WL5.

### (8. Cross-Sectional Structure of Hookup Region HR1)

FIG. 13 is a cross-sectional view taken along line XIII-XIII of FIG. 12 and showing an example of a cross-sectional structure of a hookup region HR1 of a memory layer 200 included in the memory device 1 according to the first embodiment. FIG. 13 shows an example of how the structure of the memory cell array 10 formed on the second substrate W2 is before bonding to the first substrate W1, and shows coordinate axes using the second substrate W2 as a reference. As shown in FIG. 13, the hookup region HR1 includes, for example, a plurality of contacts CC, a plurality of contacts V0 and V1, and a plurality of conductive layers 27 to 29, and insulating layers 35 to 37.

In the hookup region HR1, the end portions of the conductive layers 21 to 25 are provided in a staircase pattern and are covered with an insulating layer 35. A plurality of contacts CC are provided on the terrace portions of the select gate line SGS, the word lines WL0 to WL5 and the select gate line SGo, SGe, and SGD, respectively. Each contact CC penetrates the insulating layer 35. One conductive layer 29 is provided on each of the plurality of contacts CC. The conductive layer 29 is included in the wiring layer MO.

Each conductive layer 29 is coupled to the associated conductive layer 28 via the contact V0, the conductive layer 27, and the contact V1. It should be noted that FIG. 13 shows, among the plurality of contacts V0, the contacts V0 and V1 and the conductive layers 27 and 28 each corresponding to the select gate line SGS. The set consisting of the conductive layers 27, 28 and 29 and the contacts CC, V0 and V1 corresponds to the wirings and contacts for coupling one of the conductive layers 21 to 25 to the row decoder module 16. Although not shown, each of the conductive layers 22 and 25 is also coupled to the row decoder module 16 via the set consisting of the associated conductive layers 27, 28 and 29 and the contacts CC, V0 and V1, similarly to the conductive layer 21.

In this example, the layout and cross-sectional structure of the portion where the hookup region HR2 and the even block BLKo(BLK1, BLK3,...) of the plurality of blocks BLK overlap are the same as the layout and cross-sectional structure of the portion where the hookup region HR1 and the even block BLKe overlap, which are inverted in the X direction. The planar layout of the hookup region HR is not limited to this, and can be changed as appropriate. The hookup region HR may be arranged so as to divide the memory region MR. It suffices that the hookup region HR includes at least a plurality of contacts CC and wirings coupling the row decoder module 16 and the stacked wiring.

### (9: Cross-Sectional Structure of Memory Device 1)

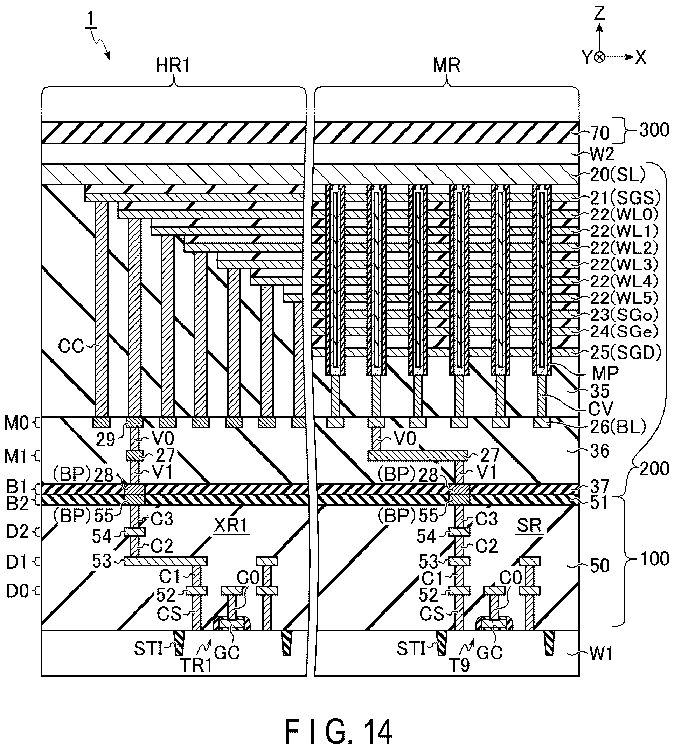

FIG. 14 is a cross-sectional view showing an example of the cross-sectional structure of the memory device 1 according to the first embodiment. FIG. 14 shows a cross section including the memory region MR and the hookup region HR1 of the memory device 1, and shows coordinate axes using the first substrate W1 as a reference. In FIG. 14, a configuration corresponding to the transistor T9 of the sense amplifier region SR and a configuration corresponding to the transistor TR1 of the transfer region XR2 are shown. As shown in FIG. 14, the memory device 1 has a structure in which the structure of the memory region MR shown in FIG. 10 and the structure of the hookup region HR1 shown in FIG. 13 are vertically inverted corresponding to the memory layer 200.

The first substrate W1 includes a plurality of well regions (not shown). A transistor or the like is formed in each of the plurality of well regions. The plurality of well regions are separated by STI (Shallow Trench Isolation), for example.

The CMOS layer 100 includes, for example, insulating layers 50 and 51, conductive layers GC and 52 to 55, and contacts CS and C0 to C3. The insulating layer 50 is provided on the first substrate W1. The insulating layer 50 covers circuits formed on the first substrate W1. The insulating layer 50 may be composed of a plurality of insulating layers. The insulating layer 50 includes wiring layers D0, D1 and D2 in this order from below. The insulating layer 51 is provided on the insulating layer 50. The insulating layer 51 is in contact with the insulating layer 35. The boundary portion between the insulating layers 51 and 35 corresponds to a bonding surface between the first substrate W1 and the second substrate W2. The insulating layer 51 is, for example, a silicon oxide film. In the descriptions below, the layer having the height where the insulating layer 51 is provided will be referred to as a "bonding layer B2".

The conductive layer GC is provided on the gate insulating film formed on the first substrate W1. The conductive layer GC in the sense amplifier region SR is used, for example, as the gate electrode of the transistor T9. The conductive layer GC in the transfer region XR2 is used, for example, as the gate electrode of the transistor TR1. The contact C0 is provided on each conductive layer GC. The two contacts CS included in the sense amplifier region SR are coupled to, for example, two impurity diffusion regions (not shown) corresponding to the source and the drain of the transistor T9. Similarly, the two contacts CS included in the transfer region XR1 are coupled to, for example, two impurity diffusion regions (not shown) corresponding to the source and the drain of the transistor TR1.

A conductive layer 52 is provided on each of the contacts CS and C0. The conductive layer 52 is included in the wiring layer D0. A conductive layer 53 is provided on the conductive layer 52, with a contact C1 interposed. The conductive layer 53 is included in the wiring layer D1. A conductive layer 54 is provided on the conductive layer 53, with a contact C2 interposed. The conductive layer 54 is included in the wiring layer D2. A conductive layer 55 is provided on the conductive layer 54, with a contact C3 interposed. The conductive layer 55 is included in the bonding layer B2 and corresponds to the bonding pad BP used for bonding the first substrate W1 and the second substrate W2. The conductive layer 55 contains, for example, copper. The conductive layer 28 being arranged to face the conductive layer 55 between the CMOS layer 100 and the memory layer 200, is in contact on the conductive layer 55. Thus, the conductive layer 26 (bit line BL) is electrically coupled to the transistor T9 provided on the first substrate W1. The conductive layer 29 is similarly electrically coupled to the transistor TR provided on the first substrate W1 via conductive layers 52 to 55 and contacts CS and C1 to C3.

An insulating layer 70 is provided on the second substrate W2. The insulating layer 70 is included in the wiring layer 300. The wiring layer 300 includes conductive layers coupled to circuits included in either the CMOS layer 100 or the memory layer 200. The conductive layers are coupled to, for example, a pad PD provided through the insulating layer 70 (not shown).

### <1-1-4> Characteristics of Transistor

Hereinafter, an example of characteristics of each transistor included in the NAND string NS in the memory device 1 according to the first embodiment will be described.

### (1: Threshold Voltage Distribution and Data Allocation of Memory Cell Transistor MT)

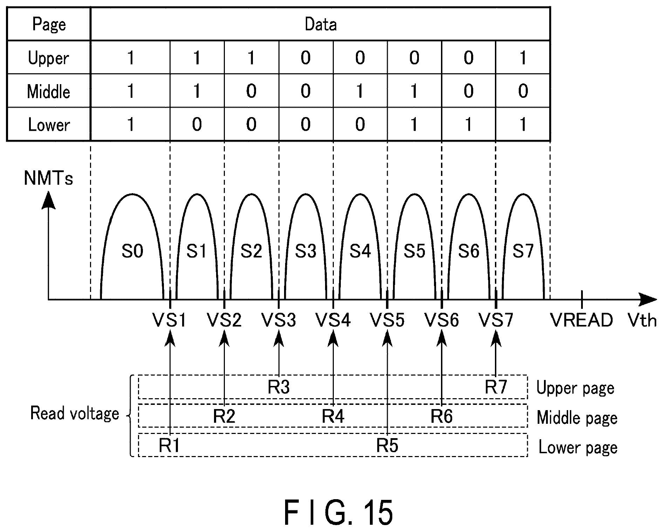

FIG. 15 is a schematic diagram showing an example of threshold voltage distribution of as memory cell transistor MT and data allocation in the memory device 1 according to the first embodiment. "NMTs" on the vertical axis indicates the number of memory cell transistors MT. "Vth" on the horizontal axis indicates the threshold voltage of the memory cell transistor MT. As shown in FIG. 15, when each memory cell transistor MT stores 3-bit data, the threshold voltage distribution of the plurality of memory cell transistors MT forms eight states. In the present specification, these eight states are referred to as an "S0" state, an "S1" state, an "S2" state, an "S3" state, an "S4" state, an "S5" state, an "S6" state, and an "S7" state, respectively, in order from a lower threshold voltage. Different 3-bit data is allocated to each of the "S0" to "S7" states. Hereinafter, an example of data allocation to eight states will be listed.
"S0" state: "111 (upper bit/middle bit/lower bit)" data
"S1" state: "110" data
"S2" state: "100" data
"S3" state: "000" data
"S4" state: "010" data
"S5" state: "011" data
"S6" state: "001" data
"S7" state: "101" data

A read voltage and a verify voltage are set between the adjacent states. Specifically, the read voltage R1 is set between the "S0" and "S1" states. The read voltage R2 is set between the "S1" and "S2" states. The read voltage R3 is set between the "S2" and "S3" states. The read voltage R4 is set between the "S3" and "S4" states. The read voltage R5 is set between the "S4" and "S5" states. The read voltage R6 is set between the "S5" and "S6" states. The read voltage R7 is set between the "S6" and "S7" states. The verify voltages VS1 to VS7 are set in association with the "S1" to "S7" states, respectively. The verify voltages VS1 to VS7 may be the same as or different from the read voltages R1 to R7, respectively. In addition, the read path voltage VREAD is set to a voltage higher than the state "S7 " having the highest threshold voltage. The memory cell transistor MT to which the read path voltage VREAD is applied is turned on regardless of the stored data.

In a case where the data allocation shown in FIG. 15 is applied, the 1-page data (lower page data) including the lower bits is determined by the read operation using the read voltages R1 and R5. The 1-page data (middle page data) including the middle bits is determined by the read operation using the read voltages R2, R4, and R6. The 1-page data (upper page data) including the upper bits is determined by the read operation using the read voltages R3 and R7. In a page read operation using a plurality of read voltages, arithmetic processing is appropriately executed in the sense amplifier unit SAU. Note that data of one bit, two bits, or four bits or more may be stored in each memory cell transistor MT, or allocation of other data may be applied.

### (2: Threshold Voltage Distribution of Select transistors STe and STo)

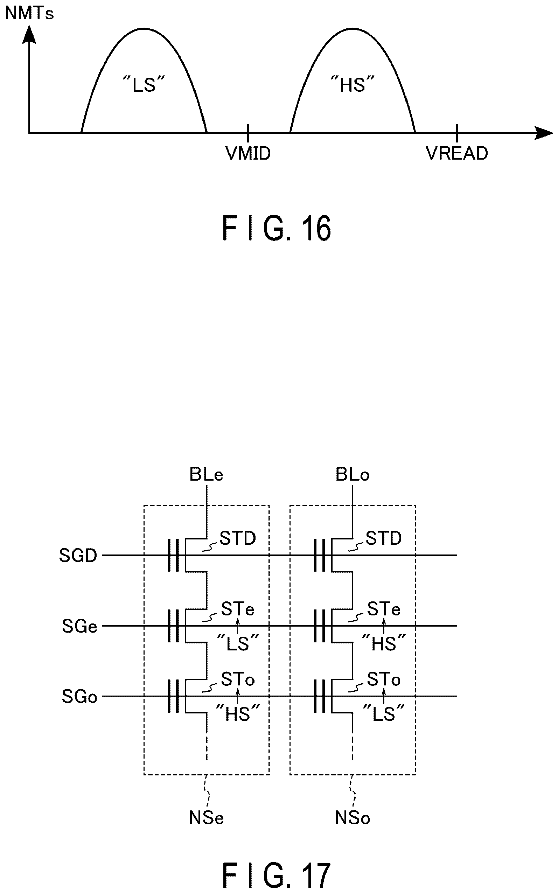

FIG. 16 is a schematic diagram showing an example of threshold voltage distribution of the select transistor STe and STo in the memory device 1 according to the first embodiment. "NMTs" on the vertical axis indicates the number of select transistors STe and STo. "Vth" on the horizontal axis indicates the threshold voltages of the select transistors STe and STo. As shown in FIG. 16, the threshold voltage distributions of the plurality of select transistors STe and STo form two states. In the present specification, these two states are referred to as an "LS" state and an "HS" state, respectively.

The "LS" state is set, for example, similarly to the" S0" state corresponding to the erase state. The "HS " state is set to a higher voltage than the "LS" state. The "HS" state may be same as any of the "S1" to "S7" states. The setting of each of the "HS" state and the "LS" state can be appropriately changed according to the threshold voltage distribution of the memory cell transistor MT. The select transistors STe and STo to which the read path voltage VREAD is applied are turned on regardless of the set state.

A read voltage VMID is set between the "LS" state and the "HS" state. As the read voltage VMID, a voltage same as any of the read voltages R1 to R7 may be used according to the setting of the "LS" state and the "HS" state. A verify voltage associated with the "HS" state may be set in the memory device 1. The "LS" state and the "HS" state are formed by, for example, writing flag data to the select transistors STe and STo. The writing of the flag data may be executed after the data of the block BLK is erased, or may be executed at the time of shipment.

FIG. 17 is a schematic diagram showing an example of threshold voltage allocation of the select transistor STe and STo in the memory device 1 according to the first embodiment. FIG. 17 shows some transistors of the NAND string NSe coupled to the even bit line BLe and some transistors of the NAND string NSo coupled to the odd bit line BLo. As shown in FIG. 17, the threshold voltage of the select transistor STe of the NAND string NSe is set to the "LS" state. The threshold voltage of the select transistor STo of the NAND string NSe is set to the "HS" state. The threshold voltage of the select transistor STe of the NAND string NSo is set to the "HS" state. The threshold voltage of the select transistor STo of the NAND string NSo is set to the "LS" state.

It should be noted that in the first embodiment, in each NAND string NS, the threshold voltage of the select transistor STe is set to one of the "LS" state and the "HS" state, and the threshold voltage of the select transistor STo is set to the other of the "LS" state and the "HS" state. Then, it suffices that the threshold voltage of the select transistor STe of the NAND string NSe is set to a state different from the threshold voltage of the select transistor STe of the NAND string NSo, and the threshold voltage of the select transistor STo of the NAND string NSe is set to a state different from the threshold voltage of the select transistor STo of the NAND string NSo. The operation of the first embodiment described below can be appropriately changed according to the state to which the select transistors STe and STo of the NAND strings NSe and NSo belong.

### <1-2> Operation

Next, a description will be given of the operation of the memory device 1 according to the first embodiment.

The memory device 1 can execute an even/odd bit line read operation, an even bit line read operation, and an odd bit line read operation. The even/odd bit line read operation is a read operation in which both the even bit line group and the odd bit line group are selected. The even bit line read operation is a read operation in which an even bit line group is selected. The odd bit line read operation is a read operation in which an odd bit line group is selected.

For example, the data size read in the even/odd bit line read operation is twice the page size read in the even bit read operation and twice the page size read in the odd bit read operation. The even/odd bit line read operation is, for example, a read operation of 16KB pages (16KB page read). Each of the even bit line read operation and the odd bit line read operation is, for example, a read operation of 8KB pages (8KB page read). The memory device 1 may be configured to perform an even bit read operation when the 8KB page read is in a first mode, and perform an odd bit read operation when the 8KB page read is in a second mode.

Hereinafter, the selected word line WL is referred to as a "word line WLsel". The non-selected word line WL is referred to as a "word line WLusel". The selected select gate line SGD is referred to as a "select gate line SGDsel". The non-selected select gate line SGD is referred to as "select gate line SGDusel". The memory cell transistor MT coupled to the word line WLsel is referred to as a "memory cell transistor MTsel". The memory cell transistor MT coupled to the word line WLusel is referred to as a "memory cell transistor MTusel". Hereinafter, a case of reading the lower page data for each of the even/odd bit line read operation, the even bit line read operation, and the odd bit line read operation executed by the memory device 1 will be described as an example.

### <1-2-1> The Even/Odd Bit Line Read Operation

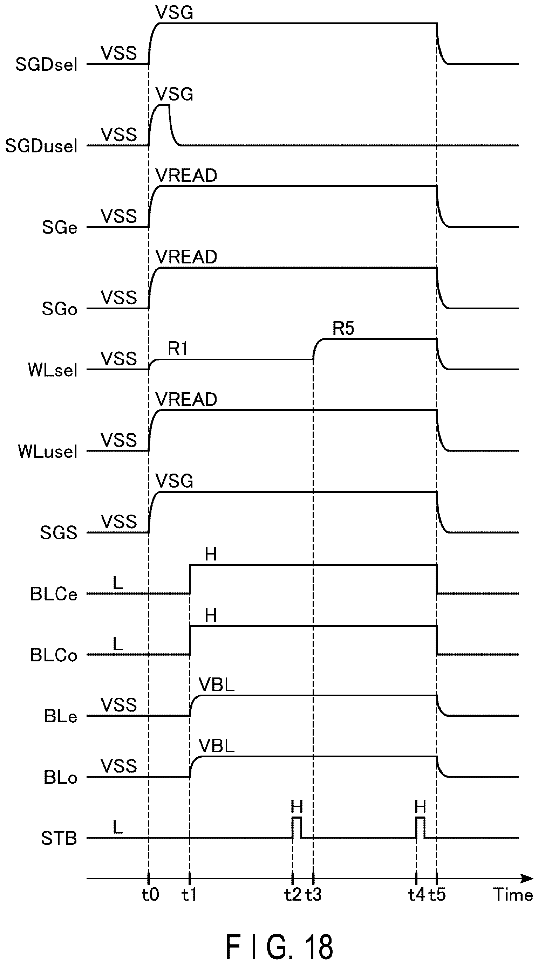

FIG. 18 is a timing chart showing an example of the even/odd bit line read operation of the memory device 1 according to the first embodiment. FIG. 18 shows changes in the voltages of the select gate lines SGDsel, SGDusel, SGe, and SGo, the word lines WLsel and WLusel, the select gate lines SGS, the control signals BLCe and BLCo, the bit lines BLe and BLo, and the control signal STB in the even/odd bit line read operation for the lower page. As shown in FIG. 18, in the even/odd bit line read operation for the lower page data, the sequencer 14 sequentially executes the processing at times t0 to t5.

At the start of the even/odd bit line read operation, the voltage applied to each wiring is the ground voltage VSS, and each control signal is at the "L" level.

At time t0, the sequencer 14 applies the voltage VSG to each of the select gate lines SGDsel, SGDusel, and SGS, applies the read path voltage VREAD to each of the select gate lines SGe and SGo and the word line WLusel, and applies the read voltage R1 to the word line WLsel. Thereafter, the sequencer 14 applies the ground voltage VSS to the select gate line SGDusel.

At time t1, the sequencer 14 sets the control signals BLCe and BLCo to the "H" level. Then, the sense amplifier unit SAUe charges the bit line BLe, and the voltage of the bit line BLe rises to the voltage VBL. Similarly, the sense amplifier unit SAUo charges the bit line BLo, and the voltage of the bit line BLo rises to the voltage VBL. Then, the memory cell transistor MTsel to which the read voltage R1 is applied is turned on or off according to the data stored therein.

Although not illustrated, between time t1 and time t2, the sequencer 14 charges the node SEN of each sense amplifier unit SAU by setting the control signal HLL to the "H" level in a predetermined period. Then, the sequencer 14 sets the control signal XXL to the "H" level. Then, the voltage of the node SEN of each sense amplifier unit SAU is discharged or maintained according to the state of the memory cell transistor MTsel associated with the sense amplifier unit SAU.

At time t2, the sequencer 14 sets the control signal STB to the "H" level in a predetermined time. That is, at time t2, the sequencer 14 asserts the control signal STB. Then, the transistor T7 of each sense amplifier unit SAU is turned on or off according to the voltage of the node SEN of the sense amplifier unit SAU. As a result, the read result using the read voltage R1 is reflected on the bus LBUS, and the read result using the read voltage R1 is stored in the predetermined latch circuit.

The operations at times t3 and t4 are the same as the operation in which the voltage applied to the word line WLsel is changed from the read voltage R1 to the read voltage R5 in the operations described at times t1 and t2, respectively. Briefly, at time t3, the sequencer 14 applies the read voltage R5 to the word line WLsel. Then, at time t4, the sequencer 14 asserts the control signal STB. As a result, the read result using the read voltage R5 is reflected on the bus LBUS, and the read result using the read voltage R5 is stored in the predetermined latch circuit.

At time t5, the sequencer 14 transitions the voltage applied to each wiring and the voltage of each control signal to the state at the start of the even/odd bit line read operation. Then, the sequencer 14 determines the lower bit data based on the read result using the read voltage R1 and the read result using the read voltage R5. Thereafter, the memory device 1 transmits the determined set of lower bit data to the memory controller 2 as lower page data, and ends the even/odd bit line reading for the lower page data.

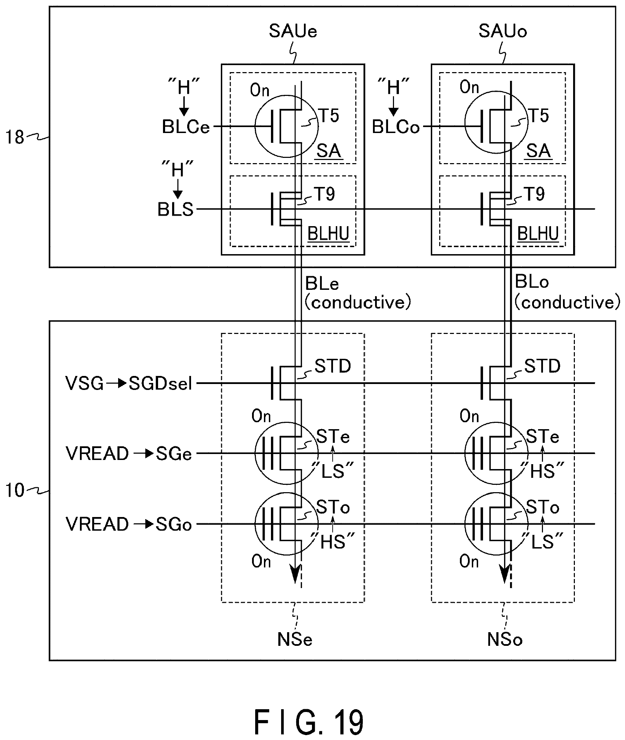

FIG. 19 is a schematic diagram showing an example of a method of selecting bit lines BL in the even/odd bit line read operation of the memory device 1 according to the first embodiment. FIG. 19 shows an operation state of some elements of each of the sense amplifier units SAUe and SAUo and the NAND strings NSe and NSo when the even/odd bit line read operation shown in FIG. 18 is executed. As shown in FIG. 19, in the even/odd bit line read operation, each of the control signals BLCe and BLCo is set to the "H" level, so that the transistor T5 of each of the sense amplifier units SAUe and SAUo is turned on.

In addition, when the control signal BLS is set to the "H" level in a period in which each of the control signals BLCe and BLCo is at the "H" level, the transistor T9 of each of the sense amplifier units SAUe and SAUo is turned on. In the NAND string NSe, each of the select transistors STe and STo to which the read path voltage VREAD is applied is turned on. In the NAND string NSo, each of the select transistors STe and STo to which the read path voltage VREAD is applied is turned on.

As a result, the sense amplifier unit SAUe and the NAND string NSe are conducted (BLe: conductive) via the even bit line BLe. Similarly, the sense amplifier unit SAUo and the NAND string NSo are conducted (BLo: conductive) via the even bit line BLe. Therefore, the memory device 1 can select each of the memory cell transistor MTsel coupled to the even bit line BLe and the memory cell transistor MTsel coupled to the odd bit line BLo and read the lower bit data in the even/odd bit line read operation shown in FIG. 18.

Note that the memory device 1 can execute the even/odd bit line read operation similarly to the lower page data by changing the read voltage and the read number in each of the middle page data and the upper page data.

### <1-2-2> Even Bit Line Read Operation

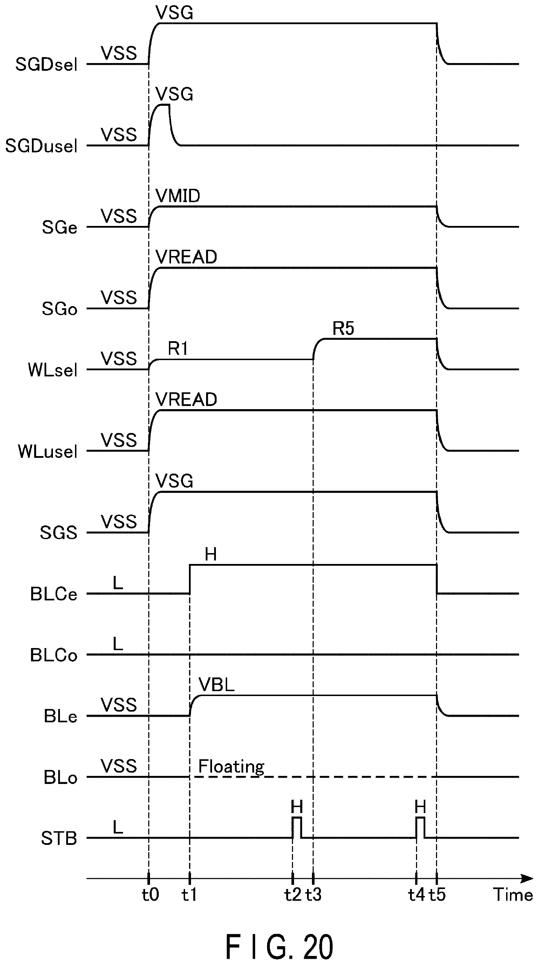

FIG. 20 is a timing chart showing an example of even bit line read operation of the memory device 1 according to the first embodiment. FIG. 20 shows changes in the voltages of the select gate lines SGDsel, SGDusel, SGe, and SGo, the word lines WLsel and WLusel, the select gate lines SGS, the control signals BLCe and BLCo, the bit lines BLe and BLo, and the control signal STB in the even bit line read operation for the lower page. As shown in FIG. 20, in the even bit line read operation for the lower page data, the sequencer 14 sequentially executes the processing at times t0 to t5.

The processing from times t0 to t5 in the even bit line read operation is different from the even/odd bit line read operation described with reference to FIG. 18 in the voltage applied to the select gate lines SGe and SGo, and in the control method of the control signals BLCe and BLCo. Specifically, at time t0 of the even bit line read operation, the sequencer 14 applies the voltage VMID to the select gate line SGe and applies the read path voltage VREAD to the select gate line SGo. At time t1, the sequencer 14 sets the control signals BLCe and BLCo to the "H" level and the "L" level, respectively. By the operation at time t1, the sense amplifier unit SAUe charges the bit line BLe to the voltage VBL. In addition, the bit line BLo goes into a floating state in a period from time t1 to time t5. The other operations of the even bit line read operation are the same as those of the even/odd bit line read operation.

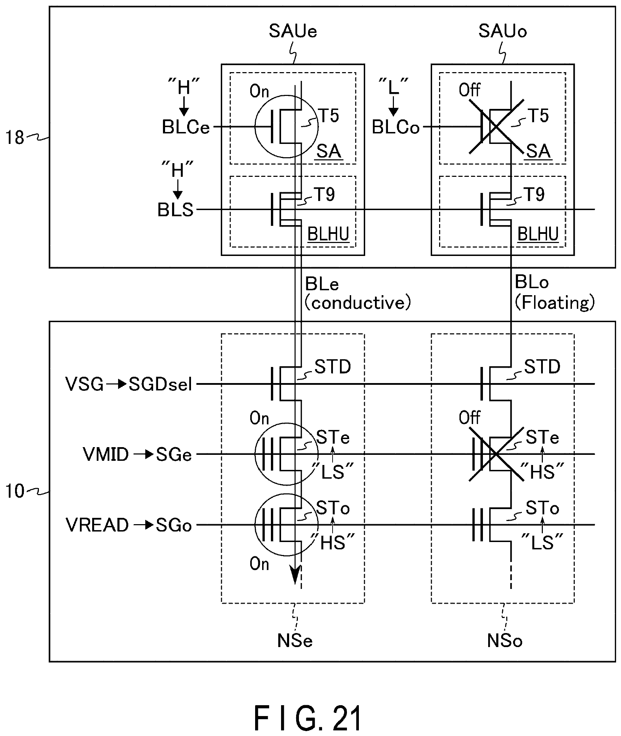

FIG. 21 is a schematic diagram showing an example of a method of selecting bit lines BL in the even bit line read operation of the memory device 1 according to the first embodiment. FIG. 21 shows an operation state of some elements of each of the sense amplifier units SAUe and SAUo and the NAND strings NSe and NSo when the even bit line read operation shown in FIG. 20 is executed. As shown in FIG. 21, in the even bit line read operation, the control signal BLCe is set to the "H" level, and the control signal BLCo is set to the "L" level. In this case, the transistor T5 of the sense amplifier unit SAUe is turned on, and the transistor T5 of the sense amplifier unit SAUo is turned off.

In addition, when the control signal BLS is set to the "H" level in a period in which each of the control signals BLCe and BLCo is respectively at the "H" level and "L" level, the transistor T9 of each of the sense amplifier units SAUe and SAUo is turned on. In the NAND string NSe, each of the select transistor STe to which the voltage VMID is applied and the select transistor STo to which the read path voltage VREAD is applied is turned on. On the other hand, in the NAND string NSo, the select transistor STe to which the voltage VMID is applied is turned off.

As a result, the sense amplifier unit SAUe and the NAND string NSe are conducted (BLe: conductive) via the even bit line BLe. On the other hand, the odd bit line BLo coupling the sense amplifier unit SAUo and the NAND string NSo goes into a floating state (BLo: Floating) as the transistor T5 of the sense amplifier unit SAUo and the select transistor STe of the NAND string NSo are in an off state. Therefore, the memory device 1 can read the lower bit data from the memory cell transistor MTsel coupled to the even bit line BLe while setting the odd bit line BLo in the floating state in the even bit line read operation shown in FIG. 20.

Note that the memory device 1 can execute the even bit line read operation similarly to the lower page data by changing the read voltage and the read number in each of the middle page data and the upper page data.

### <1-2-3> Odd Bit Line Read Operation

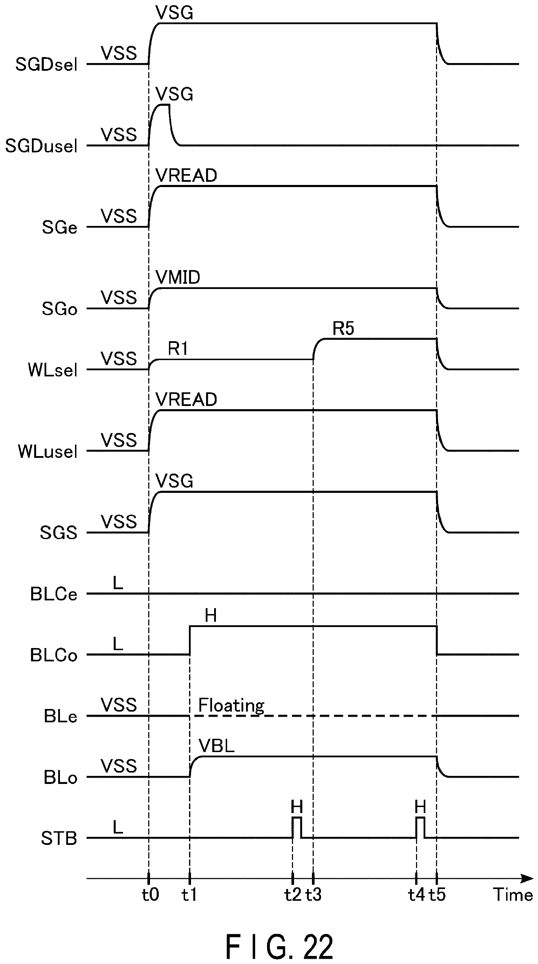

FIG. 22 is a timing chart showing an example of odd bit line read operation of the memory device 1 according to the first embodiment. FIG. 22 shows changes in the voltages of the select gate lines SGDsel, SGDusel, SGe, and SGo, the word lines WLsel and WLusel, the select gate lines SGS, the control signals BLCe and BLCo, the bit lines BLe and BLo, and the control signal STB in the odd bit line read operation for the lower page. As shown in FIG. 22, in the odd bit line read operation for the lower page data, the sequencer 14 sequentially executes the processing at times t0 to t5.

The processing from times t0 to t5 in the odd bit line read operation is different from the even/odd bit line read operation described with reference to FIG. 18 in the voltage applied to the select gate lines SGe and SGo, and in the control method of the control signals BLCe and BLCo. Specifically, at time t0 of the odd bit line read operation, the sequencer 14 applies the voltage VMID to the select gate line SGo and applies the read path voltage VREAD to the select gate line SGe. At time t1, the sequencer 14 sets the control signals BLCe and BLCo to the "L" level and the "H" level, respectively. By the operation at time t1, the sense amplifier unit SAUo charges the bit line BLo to the voltage VBL. In addition, the bit line BLe goes into a floating state in a period from time t1 to time t5. The other operations of the odd bit line read operation are the same as those of the even/odd bit line read operation.

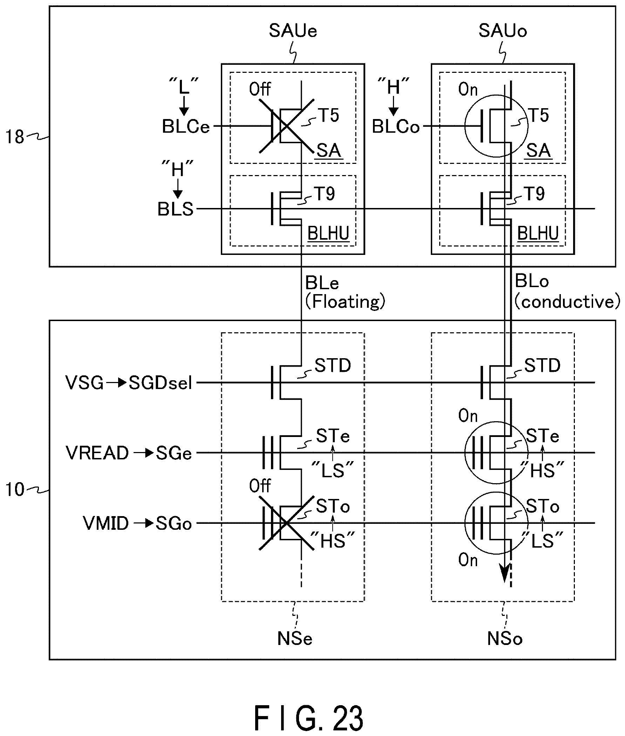

FIG. 23 is a schematic diagram showing an example of a method of selecting bit lines BL in the odd bit line read operation of the memory device 1 according to the first embodiment. FIG. 23 shows an operation state of some elements of each of the sense amplifier units SAUe and SAUo and the NAND strings NSe and NSo when the odd bit line read operation shown in FIG. 22 is executed. As shown in FIG. 23, in the odd bit line read operation, the control signal BLCo is set to the "H" level, and the control signal BLCe is set to the "L" level. In this case, the transistor T5 of the sense amplifier unit SAUo is turned on, and the transistor T5 of the sense amplifier unit SAUe is turned off.

In addition, when the control signal BLS is set to the "H" level in a period in which each of the control signals BLCe and BLCo is respectively at the "L" level and "H" level, the transistor T9 of each of the sense amplifier units SAUe and SAUo is turned on. In the NAND string NSo, each of the select transistor STe to which the read path voltage VREAD is applied and the select transistor STo to which the voltage VMID is applied is turned on. On the other hand, in the NAND string NSe, the select transistor STo to which the voltage MID is applied is turned off.

As a result, the sense amplifier unit SAUo and the NAND string NSo are conducted (BLo: conductive) via the odd bit line BLo. On the other hand, the even bit line BLe coupling the sense amplifier unit SAUe and the NAND string NSe goes into a floating state (BLe: Floating) as the transistor T5 of the sense amplifier unit SAUe and the select transistor STo of the NAND string NSe are in a turned-off state. Therefore, the memory device 1 can read the lower bit data from the memory cell transistor MTsel coupled to the odd bit line BLo while setting the even bit line BLe in the floating state in the odd bit line read operation shown in FIG. 22.

Note that the memory device 1 can execute the odd bit line read operation similarly to the lower page data by changing the read voltage and the read number in each of the middle page data and the upper page data.

### <1-3> Advantageous Effects of First Embodiment

According to the memory device according to the first embodiment described above, the operation time of the read operation can be shortened. Hereinafter, advantageous effects of the first embodiment will be described in detail.

In a flash memory in which memory cells are three-dimensionally stacked, the demand for improving the speed of a read operation, that is, shortening the operation time increases with the generation. Then, a memory device that supports not only normal 16KB page read but also 8KB page read (so-called Fast read) in which the speed of the read operation is improved is known. In the 8KB page read, for example, the apparent capacitance of the bit line BL is halved by setting every other bit line BL to the floating state. As a result, the charging time and the like of the bit line BL are shortened, and the time of the read operation can be shortened.

As a method of setting the bit line BL in the floating state, it is conceivable to increase the number of select gate lines SGD in the block BLK and control the select transistor STD coupled to the bit line BL to be set to the floating state to the turned-off state. However, in such a method, as the number of select gate lines SGD in the block BLK increases, the resistance value of the select gate line SGD increases. As a result, the operation speed of the read operation or the like may decrease. That is, in order to shorten the operation time, it is preferable to control the bit line BL to be in the floating state without increasing the number of select gate lines SGD as much as possible.

Therefore, in the memory device 1 according to the first embodiment, the NAND string NS includes the select transistor STe in which the flag data associated with the selection of the even bit line BLe is written, and the select transistor STo in which the flag data associated with the selection of the odd bit line BLo is written. These pieces of flag data are written in advance in each of the select transistors STe and STo before the read operation or the like is executed. For example, the select transistors STe and STo of the NAND string NSe coupled to the even bit line BLe are written in the "LS" state and the "HS" state, respectively, and the select transistors STe and STo of the NAND string NSo coupled to the odd bit line BLo are written in the "HS" state and the "LS" state, respectively.

Then, at the time of 16KB page read, the read path voltage VREAD is applied to each of the select transistors STe and STo such that both the select transistor written in the "LS" state and the select transistor written in the "HS" state are turned on. On the other hand, during the 8KB page read, the voltage VMID is applied to one of the select transistors STe and STo depending on which of the even bit line BLe and the odd bit line BLo is selected. As a result, the memory cell transistor MT of 8KB is electrically coupled to the bit line BL, and the remaining memory cell transistors MT of 8KB are electrically non-conductive to the bit line BL.

As described above, the memory device 1 according to the first embodiment can control any one of the select transistors STe and STo to the turned-off state. Furthermore, the memory device 1 can control the bit line BL coupled to the select transistor STe or STo in the turned-off state to be in the floating state by appropriately turning off the transistor T9 by independently controlling the control signals BLSa and BLSb.

As described above, the memory device 1 according to the first embodiment can halve the apparent capacity of the bit line BL by controlling every other bit line BL to be in the floating state. As a result, the memory device 1 according to the first embodiment can shorten the precharge time of the bit line BL in the read operation, the waiting time until the voltage of the bit line BL is stabilized, and the like, and can improve the speed of the read operation. Therefore, the memory device 1 according to the first embodiment can shorten the operation time of the read operation. In addition, the memory device 1 can halve the total current flowing through the memory cell transistor MT in the 8KB page read by controlling one of the select transistors STe and STo to the turned-off state, and can reduce the read current.

In the first embodiment, the case where the control signal BLC is independently controlled by the sense amplifier units SAUe and SAUo has been described, but the present invention is not limited thereto. The operation described in the first embodiment may be realized by independently controlling the control signal BLS instead of the control signal BLC. Even in such a case, the memory device 1 can execute an operation same as that of the first embodiment, and can obtain an advantageous effect same as that of the first embodiment.

### <2> The Second Embodiment

A memory device 1A according to a second embodiment has a configuration in which the structure in which the memory cell array 10 is stacked and the idea described in the first embodiment are combined. Details of the second embodiment will be described below, focusing mainly on the differences from the first embodiment.

### <2-1> Configuration

### <2-1-1> Overall Configuration of Memory Device 1A

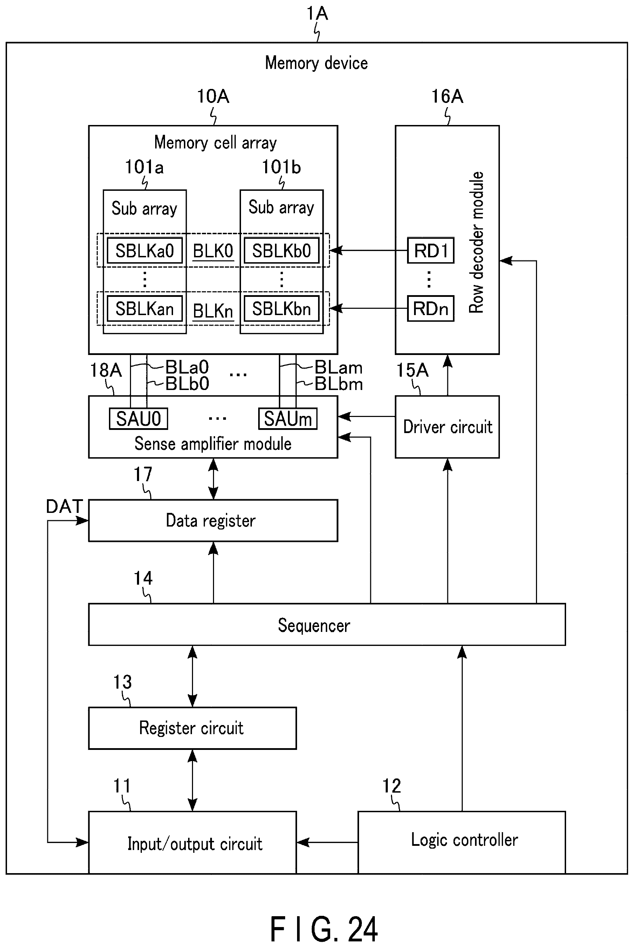

FIG. 24 is a block diagram showing an example of the overall configuration of a memory device 1A according to the second embodiment. As shown in FIG. 24, the memory device 1A includes, for example, a memory cell array 10A, an input/output circuit 11, a logic controller 12, a register circuit 13, a sequencer 14, a driver circuit 15A, a row decoder module 16A, a data register 17, and a sense amplifier module 18A. Each of the input/output circuit 11, logic controller 12, register circuit 13, sequencer 14, and data register 17 of the memory device 1A are the same as those of the first embodiment.

The memory cell array 10A includes sub arrays 101a and 101b. Each of the sub arrays 101a and 101b has a configuration same as that of the memory cell array 10 described in the first embodiment. The sub array 101a includes a plurality of sub-blocks SBLKa0 to SBLKan ("n" is an integer equal to or larger than 1). The sub array 101b includes a plurality of sub-blocks SBLKb0 to SBLKbn. The sub-blocks SBLKa0 to SBLKan are combined with the sub-blocks SBLKb0 to SBLKbn, respectively. In the memory cell array 10A, a set consisting of the combined sub-blocks SBLKa and SBLKb constitutes one block BLK. Bit lines BLa0 to BLam ("m" is an integer equal to or larger than 1) are coupled to the sub-blocks SBLKa0 to SBLKan. Bit lines BLb0 to BLbm are coupled to the sub-blocks SBLKb0 to SBLKbn.

The driver circuit 15A has a configuration in which the driver circuit 15 of the first embodiment is modified according to the memory cell array 10A. The driver circuit 15A generates voltages to be applied to various wirings provided in the sub array 101a and the sub array 101b.

The row decoder module 16A has a configuration in which the row decoder module 16 of the first embodiment is modified according to the memory cell array 10A. The row decoder module 16A transfers voltages generated by the driver circuit 15A to various wirings provided in the sub array 101a and the sub array 101b.

The sense amplifier module 18A has a configuration in which the sense amplifier module 18 of the first embodiment is modified according to the memory cell array 10A. Each sense amplifier unit SAU of the sense amplifier module 18A is coupled to a set of bit lines BLa and BLb. Specifically, the sense amplifier units SAUO to SAUm are coupled to the bit lines BLa0 to BLam, respectively, and are further coupled to the bit lines BLbO to BLbm, respectively.

### <2-1-2> Circuit Configuration of Memory Device 1A

Hereinafter, a description will be given of the circuit configuration of the memory device 1A according to the first embodiment.

### (1: Circuit Configuration of Memory Cell Array 10A)

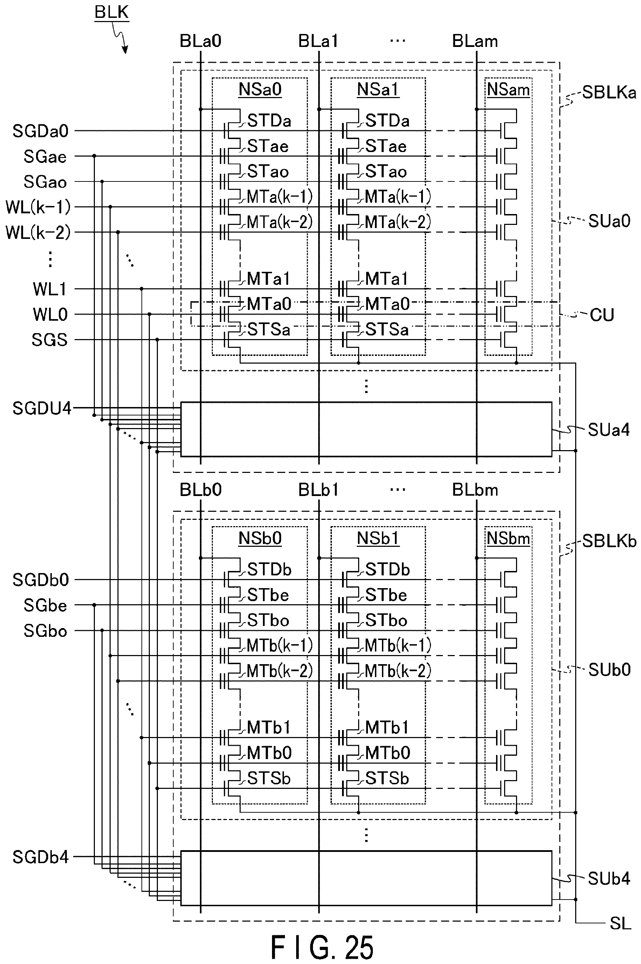

FIG. 25 is a circuit diagram showing an example of the circuit configuration of the memory cell array 10A included in the memory device 1A according to the second embodiment. FIG. 25 shows one block BLK that is among a plurality of blocks BLK included in the memory cell array 10A. As shown in FIG. 25, in the block BLK of the second embodiment, for example, the select gate line SGS, the word lines WL0 to WL (k-1) (k is an integer equal to or larger than 1), and the source line SL are coupled to the sub-blocks SBLKa and SBLKb, respectively. The bit lines BLa0 to BLam and the select gate lines SGDa0 to SGDa4, SGae, and SGao are coupled to the sub-block SBLKa. The bit lines BLbO to BLbm and the select gate lines SGDb0 to SGDb4, SGbe, and SGbo are coupled to the sub-block SBLKb.

In the block BLK of the second embodiment, the select gate lines SGDa0 to SGDa4, the select gate lines SGDb0 to SGDb4, the select gate lines SGae, SGao, SGbe, and SGbo, the select gate line SGS, and the word lines WL0 to WL (k-1) are provided for each block BLK. The bit lines BLa0 to BLam are shared by a plurality of sub-blocks SBLKa. The bit lines BLb0 to BLbm are shared by a plurality of sub-blocks SBLKb. The source line SL is shared by a plurality of blocks BLK.

The sub-block SBLKa includes, for example, five string units SUa0 to SUa4. Each string unit SUa includes a plurality of NAND strings NSa0 to NSam. The NAND strings NSa0 to NSam are associated with the bit lines BLa0 to BLam, respectively. The NAND string NSa is coupled between the associated bit line BLa and the source line SL. Each NAND string NSa includes, for example, k memory cell transistors MTa0 to MTa(k-1) and select transistors STDa, STae, STao, and STSa. In each NAND string NSa, the select transistors STDa, STae, and STao, the memory cell transistors MTa (k-1) to MTaO, and the select transistor STSa are coupled in series in this order from the bit line BLa toward the source line SL. Each of the select transistors STDa and STSa is used to select the string unit SUa. Each of the select transistors STae and STao are used to select a group of the bit lines BLa.

The sub-block SBLKb includes, for example, five string units SUb0 to SUb4. Each string unit SUb includes a plurality of NAND strings NSbO to NSbm. The NAND strings NSbO to NSbm are associated with the bit lines BLbO to BLbm, respectively. The NAND string NSb is coupled between the associated bit line BLb and the source line SL. Each NAND string NSb includes, for example, k memory cell transistors MTbO to MTb(k-1) and select transistors STDb, STbe, STbo, and STSb. In each NAND string NSb, the select transistors STDb, STbe, and STbo, the memory cell transistors MTb (k-1) to MTbO, and the select transistor STSb are coupled in series in this order from the bit line BLb toward the source line SL. Each of the select transistors STDb and STSb is used to select the string unit SUb. Each of the select transistors STbe and STbo are used to select a group of the bit lines BLb.

In the second embodiment, a case where an even bit line group including the even bit line BLae(BLa0, BLa2, BLa4,...) and an odd bit line group including the odd bit line BLao(BLa1, BLa3, BLa5,...) are configured to be individually selectable among the plurality of bit lines BLa0 to BLam coupled to the sub-block SBLKa will be described as an example. In this case, the memory device 1A is configured such that the even bit line group including the even bit line BLbe(BLb0, BLb2, BLb4,...) and the odd bit line group including the odd bit line BLbo(BLb1, BLb3, BLb5,...) are configured to be individually selectable among the plurality of bit lines BLb0 to BLbm coupled to the sub-block SBLKb.

The select gate lines SGDa0 to SGDa4 are associated with the string units SUa0 to SUa4, respectively. Each select gate line SGDa is coupled to respective gates of a plurality of select transistors STDa included in the associated string unit SUa. The select gate line SGae is coupled to each of the gates of a plurality of select transistors STae included in the sub-block SBLKa. The select gate line SGao is coupled to each of the gates of a plurality of select transistors STao included in the sub-block SBLKa.

The select gate lines SGDb0 to SGDb4 are associated with the string units Sub0 to Sub4, respectively. Each select gate line SGDb is coupled to respective gates of a plurality of select transistors STDb included in the associated string unit SUb. The select gate line SGbe is coupled to each of the gates of a plurality of select transistors STbe included in the sub-block SBLKb. The select gate line SGbo is coupled to each of the gates of a plurality of select transistors STbo included in the sub-block SBLKb.

The select gate line SGS of the second embodiment is coupled to each of the gates of a plurality of select transistors STSa and STSb included in the block BLK. The word line WL(K) ("K" is an integer from 0 to (k-1), for example) of the second embodiment is coupled to the each of the control gates of the plurality of memory cell transistors MTa(K) and MTb(K) included in the block BLK.

As described above, in the memory cell array 10A, the word line WL is shared in a set of the sub-blocks SBLKa and SBLKb. The select gate line SGD is provided for each string unit SU. The select gate lines SGa and SGa are provided for each sub-block SBLK. The select gate line SGS may be shared within the block BLK, may be provided for each sub-block SBLK, or may be provided for each string unit SU.

It should be noted that the memory cell array 10A may have other circuit configurations. For example, the numbers of string units SUa and SUb included in the block BLK, the numbers of memory cell transistors MTa and select transistors STDa, STae, STao, and STSa included in the NAND string NSa, and the numbers of memory cell transistors MTb and select transistors STDb, STbe, STbo, and STSb included in the NAND string NSb can be designed to be any number. Hereinafter, a case where the number of memory cell transistors MTa included in the NAND string NSa is six and the number of memory cell transistors MTb included in the NAND string NSb is six will be described as an example.

### (2: Circuit Configuration of Row Decoder Module 16A)

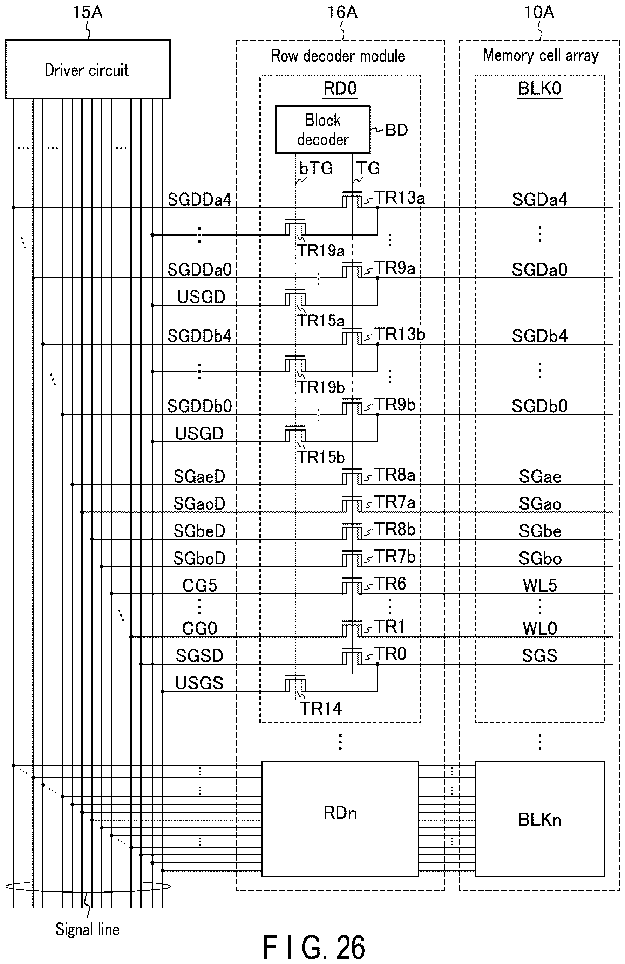

FIG. 26 is a circuit diagram showing an example of the circuit configuration of a row decoder module 16A included in the memory device 1A according to the second embodiment. FIG. 26 shows how the driver circuit 15A and the memory cell array 10A are coupled to the row decoder module 16A, and also shows a detailed circuit configuration of one row decoder RD. As shown in FIG. 25, the row decoder RD of the second embodiment is coupled to each of signal lines CG0 to CG5, SGDDaO to SGDDa4, SGDDb0 to SGDDb4, SGaeD, SGaoD, SGbeD, SGboD, SGSD, USGD, and USGS, which are coupled to the driver circuit 15A. In addition, the row decoder RD of the second embodiment is coupled to the word lines WL0 to WL5 of the associated block BLK, and to the select gate lines SGDa0 to SGDa4, SGDb0 to SGDb4, SGae, SGao, SGbe, SGbo, and SGS.

The row decoder RD of the second embodiment includes, for example, transistors TR0 to TR6, TR7a to TR13a, TR7b to TR13b, TR14, TR15a to TR19a, TR15b to TR19b, transfer gate lines TG and bTG, and a block decoder BD. The transistors TR0 to TR6 and TR14 and the block decoder BD are the same as those of the row decoder RD of the first embodiment. Each of the transistors TR7a to TR13a, TR15a to TR19a, TR7b to TR13b, and TR15b to TR19b is an n-type HV transistor. The transfer gate line TG of the second embodiment is coupled to each of the gates of the transistors TR7a to TR13a and TR7b to TR13b. The transfer gate line bTG of the second embodiment is coupled to each of the gates of the transistors TR15a to TR19a and TR15b to TR19b.

The drains of the transistors TR7a to TR8a are coupled to signal lines SGaoD and SGaeD, respectively. The sources of the transistors TR7a and TR8a are coupled to the select gate lines SGao and SGae of the associated block BLK, respectively. The drains of the transistors TR9a to TR13a are respectively coupled to signal lines SGDDa0 to SGDDa4, respectively. The sources of the transistors TR9a to TR13a are coupled to the select gate lines SGDa0 to SGDa4 of the associated block BLK, respectively. The drains of the transistors TR15a to TR19 are coupled to the respective signal line USGD. The sources of the transistors TR15a to TR19a are coupled to the select gate lines SGDa0 to SGDa4 of the associated block BLK, respectively.

The drains of the transistors TR7b to TR8b are coupled to signal lines SGboD and SGbeD, respectively. The sources of the transistors TR7b and TR8b are coupled to the select gate lines SGbo and SGbe of the associated block BLK, respectively. The drains of the transistors TR9b to TR13b are coupled to signal lines SGDDb0 to SGDDb4, respectively. The sources of the transistors TR9b to TR13b are coupled to the select gate lines SGDb0 to SGDb4 of the associated block BLK, respectively. Each of the drains of the transistors TR15b to TR19b is coupled to the signal line USGD. The sources of the transistors TR15b to TR19b are coupled to the select gate lines SGDb0 to SGDb4 of the associated block BLK, respectively.

It should be noted that the row decoder module 16A may have other circuit configurations. The number of transistors TR included in the row decoder module 16A can be appropriately changed in accordance with the number of wirings provided in each block BLK.

### (3: Circuit Configuration of Sense Amplifier Unit SAU)

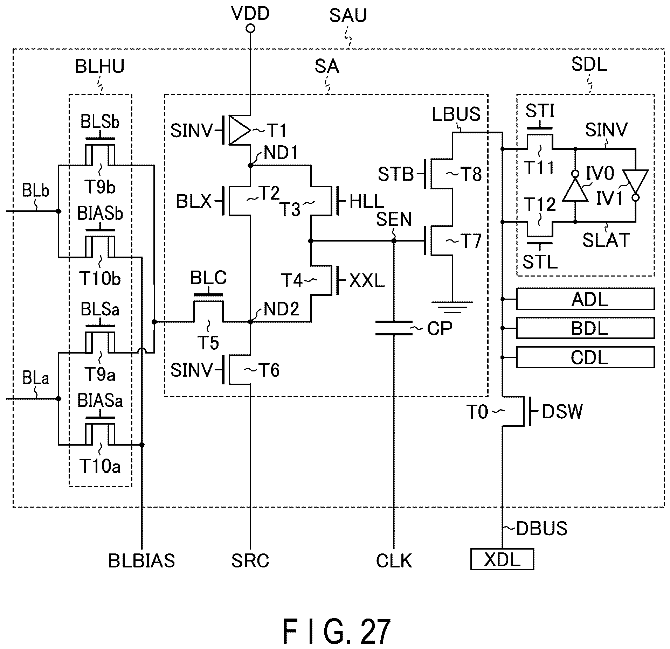

FIG. 27 is a circuit diagram showing an example of a circuit configuration of the sense amplifier unit SAU included in the sense amplifier module 18A of the memory device 1A according to the second embodiment. The sense amplifier unit SAU of the second embodiment is different from the sense amplifier unit SAU of the first embodiment in the circuit configuration of the bit line connection unit BLHU. The bit line connection unit BLHU of the second embodiment includes, for example, transistors T9a, T10a, T9b, and T10b. A set of transistors T9a and T10a and a set of transistors T9b and T10b are same as the set of transistors T9 and T10 of the first embodiment, and are configured to be individually controllable.

Specifically, each of the drains of the transistors T9a and T9b is coupled to the source of the transistor T5. The sources of the transistors T9a and T9b are coupled to the bit lines BLa and BLb, respectively. Each of the drains of the transistors T10a to T10b is coupled to the node BLBIAS. The sources of the transistors T10a and T10b are coupled to the bit lines BLa and BLb, respectively. The control signals BLSa and BLSb are input to the gates of the transistors T9a and T9b, respectively. The control signals BIASa and BIASb are input to the gate of the transistors T10a and T10b, respectively.

Other configurations of the sense amplifier unit SAU of the second embodiment are the same as those of the sense amplifier unit SAU of the first embodiment. Hereinafter, the sense amplifier unit SAU coupled to a set of the even bit line BLae and BLbe is referred to as a "sense amplifier unit SAUe". The sense amplifier unit SAU coupled to a set of the odd bit line BLao and BLbo is referred to as a "sense amplifier unit SAUo". In the second embodiment, the sequencer 14 is configured to be able to independently control the control signals BLSa, BLSb, BIASa, and BIASb used to control the sense amplifier unit SAUe, and the control signals BLSa, BLSb, BIASa, and BIASb used to control the sense amplifier unit SAUo. Hereinafter, the control signals BLSa, BLSb, BIASa, and BIASb used to control the sense amplifier unit SAUe are referred to as control signals BLSae, BLSbe, BIASae, and BIASbe, respectively. The control signals BLSa, BLSb, BIASa, and BIASb used to control the sense amplifier unit SAUo are referred to as control signals BLSao, BLSbo, BIASao, and BIASbo, respectively.

### <2-1-3> Structure of Memory Device 1A

Hereinafter, a description will be given of the structure of the memory device 1A according to the second embodiment.

### (1: Appearance of Memory Device 1A)

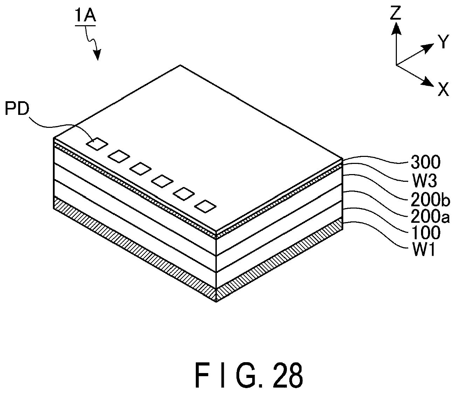

FIG. 28 is a perspective view showing an example of the appearance of the memory device 1A according to the second embodiment. As shown in FIG. 28, the memory device 1A has a structure in which, for example, a first substrate W1, a CMOS layer 100, a memory layer 200a, a memory layer 200b, a third substrate W3, and a wiring layer 300 are stacked in this order from below.

The CMOS layer 100 of the second embodiment includes, for example, an input/output circuit 11, a logic controller 12, a register circuit 13, a sequencer 14, a driver circuit 15A, a row decoder module 16A, a data register 17, and a sense amplifier module 18A. The memory layer 200a includes a sub array 101a formed using the second substrate W2. In this example, the second substrate W2 is removed after the first substrate W1 and the second substrate W2 are bonded. The memory layer 200b includes a sub array 101b formed using the third substrate W3.

The third substrate W3 is a silicon substrate. The memory device 1A has a bonding surface between the CMOS layer 100 and the memory layer 200a and between the memory layers 200a and 200b. In this example, the surface of the CMOS layer 100 on the first substrate W1 and the surface of the memory layer 200a on the second substrate W2 are bonded by the bonding process of the first substrate W1 and the second substrate W2. Alternatively, the first substrate W1 and the second substrate W2 are bonded, and the resultant substrate (bonded substrate) is bonded to the third substrate W3. By doing so, the surface of the memory layer 200a on the bonded substrate and the surface of the memory layer 200b on the third substrate W3 are bonded. It should be noted that the third substrate W3 may be removed after the bonded substrate and the third substrate W3 are bonded. In this case, the memory device 1A does not have the third substrate W3.

### (2: Cross-Sectional Structure of Memory Device 1A)

Hereinafter, a description will be given of the cross-sectional structure of the memory device 1A according to the second embodiment. In the memory device 1A, the cross-sectional structure of the CMOS layer 100 is similar to that of the first embodiment. Each of the memory layers 200a and 200b has, for example, a configuration similar to that of the memory layer 200 of the first embodiment. In the descriptions below, with respect to components similar to those of the memory layer 200, "a" is added to the end of the reference numerals where they are components of the memory layer 200a, and "b" is added to the end of the reference numerals where they are components of the memory layer 200b.

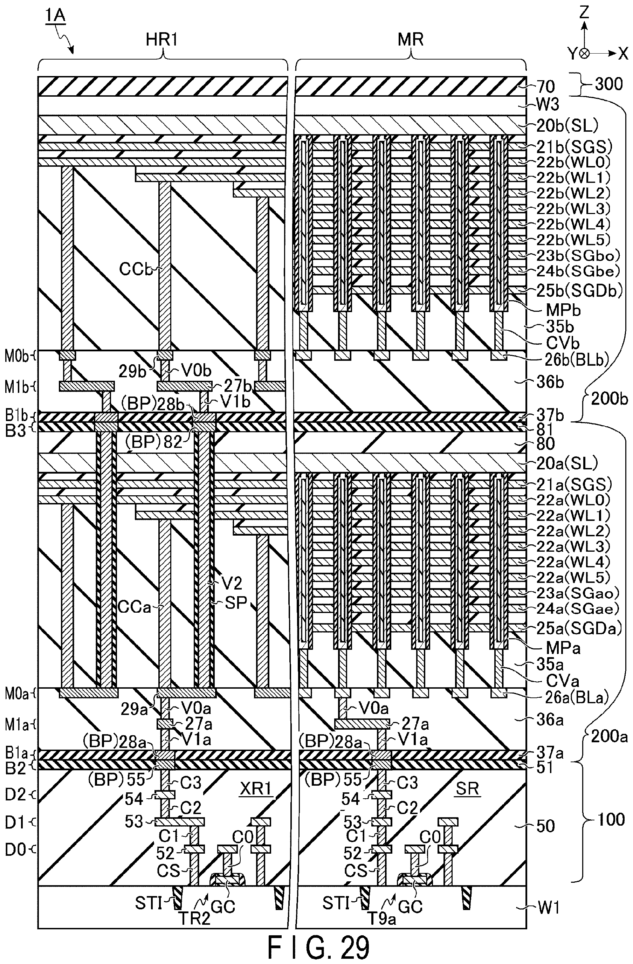

FIG. 29 is a cross-sectional view showing an example of the cross-sectional structure of the memory device 1A according to the second embodiment. FIG. 29 shows a cross section including the memory region MR and the hookup region HR1 of the memory device 1A, and shows coordinate axes using the first substrate W1 as a reference. As shown in FIG. 29, the memory layer 200a differs from the memory layer 200 of the first embodiment, for example, in that the second substrate W2 is omitted and insulating layers 80 and 81, a conductive layer 82 and a contact V2 are added. The memory layer 200b differs from the memory layer 200 of the first embodiment, for example, in that the second substrate W2 is replaced with a third substrate W3. An insulating layer 70 (wiring layer 300) is provided on the third substrate W3, similarly to the memory layer 200 of the first embodiment.

In the memory layer 200a, the conductive layer 26a (bit line BLa) is coupled to the sense amplifier unit SA (transistor T9a) provided on the first substrate W1, via conductive layers 27a, 28a, 52 to 55 and contacts V0a, V1a, C1 to C3 and CS, similarly to the memory layer 200 of the first embodiment. Similarly, the conductive layer 22a (e.g., word line WL1) is coupled to the row decoder RD (e.g., transistor TR2) on the first substrate W1, via conductive layers 27a to 29a and 52 to 55 and contacts V0a, V1a, C1 to C3 and CS, etc. Similarly to the conductive layer 22a, the other conductive layers 21a to 25a are also coupled to the row decoder RD on the first substrate W1.

In the memory layer 200a, the insulating layer 80 is provided on the conductive layer 20a. The insulating layer 81 is provided on the insulating layer 80. The insulating layer 81 is in contact with the bonding surfaces of the memory layers 200a and 200b. In the descriptions below, the layer having the height where the insulating layer 81 is provided will be referred to as a "bonding layer B3". The conductive layer 82 is included in the bonding layer B3 and corresponds to the bonding pad BP. The contact V2 is included in the hookup region HR1. The contact V2 is provided through the terrace portions of the stacked wirings of the memory layer 200a and couples the associated conductive layer 29a and conductive layer 82 to each other. A side surface of the contact V2 is covered with a spacer SP. This spacer SP is formed of an insulating member, and insulates the contact V2 from the stacked wirings of the memory layer 200a.

In the memory layer 200b, the insulating layer 37b is in contact with the bonding surfaces of the memory layers 200a and 200b. Each conductive layer 28b is included in the bonding layer B1b. Each conductive layer 28b is arranged opposite to the conductive layer 82 of the memory layer 200a and is bonded thereto. Thus, the conductive layer 22b (e.g., the word line WL1) is electrically coupled to the associated conductive layer 82 in the memory layer 200a, via the conductive layers 27b to 29b and the contacts V0b and V1b. As a result, the conductive layers 22a and 22b associated with the same word line WL1 are electrically coupled. Similarly to the conductive layer 22b, the conductive layers 21b to 25b are electrically coupled to the associated conductive layers 21a to 25a, respectively.

In addition, in the memory layer 200b, the conductive layer 26b (bit line BLb) is coupled to the sense amplifier unit SA (transistor T9b) provided on the first substrate W1, via conductive layers 27a, 27b, 28a, 28b, 29a, 29b, 52 to 55 and contacts V0a, V0b, V1a, V1b, C1 to C3 and CS. Other structures of the memory device 1A according to the second embodiment are the same as those of the memory device 1 according to the first embodiment.

### <2-1-4> Characteristics of Transistor

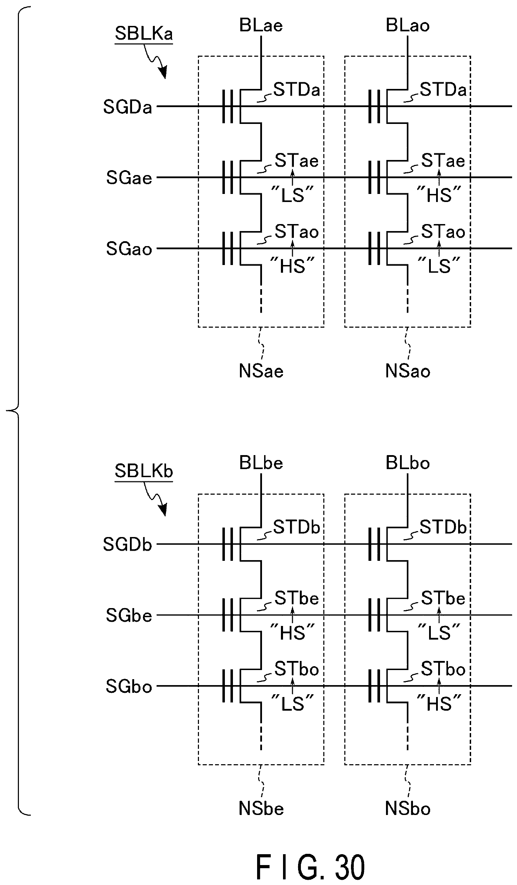

FIG. 30 is a schematic diagram showing an example of threshold voltage allocation of the select transistor STae, STbe, and STao and STbo in the memory device 1A according to the second embodiment. FIG. 30 shows some transistors of the NAND string NSae coupled to the even bit line BLae and some transistors of the NAND string NSao coupled to the bit line BLao in the sub-block SBLKa, and some transistors of the NAND string NSbe coupled to the even bit line BLbe and some transistors of the NAND string NSbo coupled to the odd bit line BLbo in the sub-block SBLKb.

As shown in FIG. 30, the threshold voltage of the select transistor STae of the NAND string NSae is set to the "LS" state. The threshold voltage of the select transistor STao of the NAND string NSae is set to the "HS" state. The threshold voltage of the select transistor STae of the NAND string NSao is set to the "HS" state. The threshold voltage of the select transistor STao of the NAND string NSao is set to the "LS" state. The threshold voltage of the select transistor STbe of the NAND string NSbe is set to the "HS" state. The threshold voltage of the select transistor STbo of the NAND string NSbe is set to the "LS" state. The threshold voltage of the select transistor STbe of the NAND string NSbo is set to the "LS" state. The threshold voltage of the select transistor STbo of the NAND string NSbo is set to the "HS" state.

It should be noted that in the second embodiment, in each NAND string NSae of the sub-block SBLKa, the threshold voltage of the select transistor STae is set to one of the "LS" state and the "HS" state, and the threshold voltage of the select transistor STao is set to the other of the "LS" state and the "HS" state. Then, it suffices that the threshold voltage of the select transistor STae of the NAND string NSao is set to a state different from the threshold voltage of the select transistor STae of the NAND string NSae, and the threshold voltage of the select transistor STao of the NAND string NSao is set to a state different from the threshold voltage of the select transistor STao of the NAND string NSae.

Similarly, in the second embodiment, in each NAND string NSbe of the sub-block SBLKb, the threshold voltage of the select transistor STbe is set to one of the "LS" state and the "HS" state, and the threshold voltage of the select transistor STbo is set to the other of the "LS" state and the "HS" state. Then, it suffices that the threshold voltage of the select transistor STbe of the NAND string NSbo is set to a state different from the threshold voltage of the select transistor STbe of the NAND string NSbe, and the threshold voltage of the select transistor STbo of the NAND string NSbo is set to a state different from the threshold voltage of the select transistor STbo of the NAND string NSbe.

In addition, in the second embodiment, the threshold voltage of the select transistor STae of each NAND string NSae is set to a state different from the threshold voltage of the select transistor STbe of the NAND string NSbe, and the threshold voltage of the select transistor STao of the NAND string NSae is set to a state different from the threshold voltage of the select transistor STbo of the NAND string NSbe. The threshold voltage of the select transistor STae of each NAND string NSao is set to a state different from the threshold voltage of the select transistor STbe of the NAND string NSbo, and the threshold voltage of the select transistor STao of the NAND string NSao is set to a state different from the threshold voltage of the select transistor STbo of the NAND string NSbo.

That is, the threshold voltages of the select transistors ST arranged in the same layer in the NAND string NSae and the NAND string NSao are set to different levels. The threshold voltages of the select transistors ST arranged in the same layer in the NAND string NSbe and the NAND string NSbo are set to different levels. The threshold voltages of the select transistors ST arranged in the same layer in the NAND string NSae and the NAND string NSbe are set to different levels. The threshold voltages of the select transistors ST arranged in the same layer in the NAND string NSao and the NAND string NSbo are set to different levels.

Note that "the same layer" indicates that, in a case where the sub-blocks SBLK to which the select transistor ST to be compared belongs are different, the relative position of the select transistor ST in the sub-block SBLKa and the relative position of the select transistor ST in the sub-block SBLKb have the same height. The operation of the second embodiment described below can be appropriately changed according to the state to which the respective select transistors STae and STao of the NAND strings NSae and NSao belong and the state to which the respective select transistors STbe and STbo of the NAND strings NSbe and NSbo belong.

### <2-2> Operation

Next, a description will be given of the operation of the memory device 1A according to the second embodiment. The memory device 1A can execute a first read operation, a second read operation, a shield read operation, and a write operation. Hereinafter, details of the first read operation, the second read operation, the shield read operation, and the write operation will be sequentially described.

### <2-2-1> First Read Operation

The first read operation is a read operation in which an even bit line group (even bit line BLae) is selected in the sub-block SBLKa and an odd bit line group (odd bit line BLbo) is selected in the sub-block SBLKb. In the first read operation, the memory device 1A executes an operation similar to the even bit line read operation for the sub-block SBLKa and executes an operation similar to the odd bit line read operation for the sub-block SBLKb. In the first read operation, one string unit SU is selected in each of the associated sub-blocks SBLKa and SBLKb. That is, in the first read operation, one select gate line SGDa and one select gate line SGDb are selected.

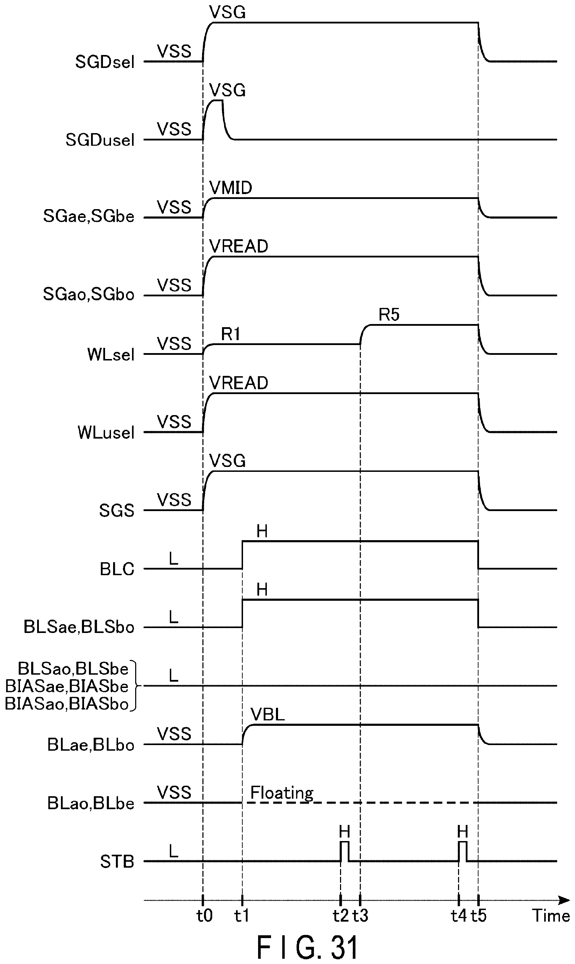

FIG. 31 is a timing chart showing an example of first read operation of the memory device 1A according to the second embodiment. FIG. 31 shows changes in the voltages of the select gate lines SGDsel and SGDusel, the select gate lines SGae, SGbe, SGao and SGbo, the word lines WLsel and WLusel, the select gate lines SGS, the control signals BLC, BLSae, BLSbe, BLSao, BLSbo, BIASae, BIASbe, BIASao, and BIASbo, the bit lines BLae, BLbe, BLao, and BLbo, and the control signal STB in the first read operation for the lower page. As shown in FIG. 31, in the first read operation for the lower page data, the sequencer 14 sequentially executes the processing at times t0 to t5.

At the start of the first read operation, the voltage applied to each wiring is the ground voltage VSS, and each control signal is at the "L" level.

At time t0, the sequencer 14 applies the voltage VSG to each of the select gate lines SGDsel, SGDusel, and SGS, applies the read path voltage VREAD to each of the select gate lines SGao and SGbo and the word line WLusel, applies the voltage VMID to each of the select gate lines SGae and SGbe, and applies the read voltage R1 to the word line WLsel. Thereafter, the sequencer 14 applies the ground voltage VSS to the select gate line SGDusel.

At time t1, the sequencer 14 sets the control signals BLC, BLSae and BLSbo to the "H" level. Then, the sense amplifier unit SAUe charges the bit line BLae, and the voltage of the bit line BLae rises to the voltage VBL. Similarly, the sense amplifier unit SAUo charges the bit line BLbo, and the voltage of the bit line BLbo rises to the voltage VBL. Then, the memory cell transistor MTsel to which the read voltage R1 is applied is turned on or off based on the data stored therein. In addition, each of the bit lines BLao and BLbe goes into a floating state.

At time t2, the sequencer 14 asserts the control signal STB. Then, the transistor T7 of each sense amplifier unit SAU is turned on or off according to the voltage of the node SEN of the sense amplifier unit SAU. As a result, the read result using the read voltage R1 is reflected on the bus LBUS, and the read result using the read voltage R1 is stored in the predetermined latch circuit.

The operations at times t3 and t4 are the same as the operation in which the voltage applied to the word line WLsel is changed from the read voltage R1 to the read voltage R5 in the operations described at times t1 and t2, respectively. Briefly, at time t3, the sequencer 14 applies the read voltage R5 to the word line WLsel. Then, at time t4, the sequencer 14 asserts the control signal STB. As a result, the read result using the read voltage R5 is reflected on the bus LBUS, and the read result using the read voltage R5 is stored in the predetermined latch circuit.

At time t5, the sequencer 14 transitions the voltage applied to each wiring and the voltage of each control signal to the state at the start of the first read operation. Then, the sequencer 14 determines the lower bit data based on the read result using the read voltage R1 and the read result using the read voltage R5. Thereafter, the memory device 1 transmits the determined set of lower bit data to the memory controller 2 as lower page data, and ends the first reading for the lower page data.

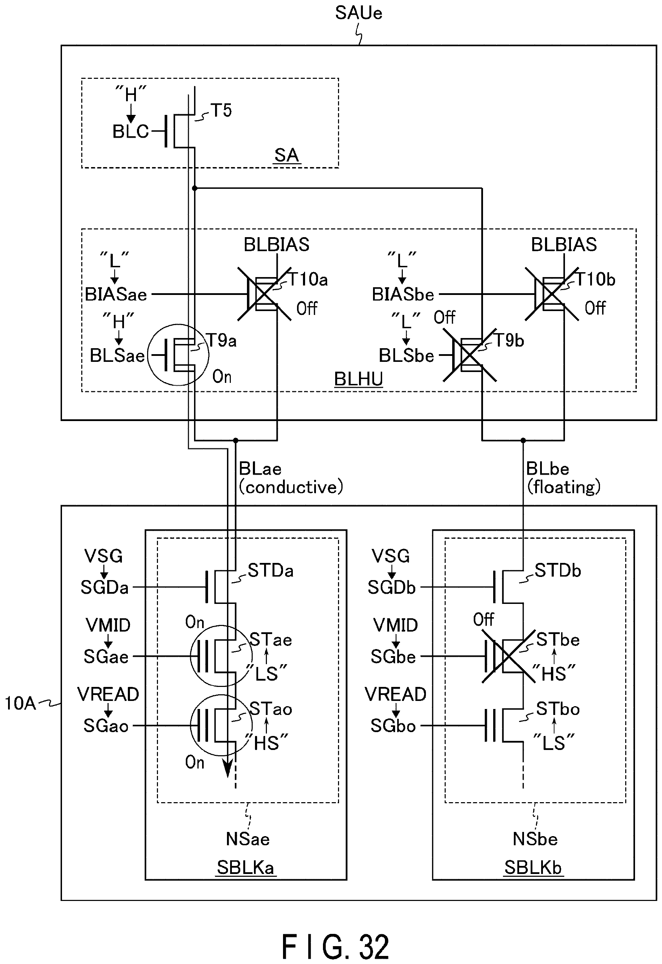

FIG. 32 is a schematic diagram showing an example of a method of selecting a bit line BL in the first read operation of the memory device 1A according to the second embodiment. FIG. 32 shows an operation state of some elements of each of the sense amplifier units SAUe and the NAND strings NSae and NSbe when the first read operation shown in FIG. 31 is executed. As shown in FIG. 32, in the first read operation, the control signal BLC is set to the "H" level, so that the transistor T5 of the sense amplifier unit SAUe is turned on.

In addition, the control signal BLSae is set to the "H" level, so that the transistor T9a of the sense amplifier unit SAUe is turned on. Each of the control signals BLSbe, BIASae, and BIASbe is set to the "L" level, so that the transistors T9b, T10a, and T10b of the sense amplifier unit SAUe are turned off. In the NAND string NSae, each of the select transistor STae to which the voltage VMID is applied and the select transistor STao to which the read path voltage VREAD is applied is turned on. On the other hand, in the NAND string NSbe, the select transistor STbe to which the voltage VMID is applied is turned off.

As a result, the sense amplifier unit SAUe and the NAND string NSae are conducted (BLae: conductive) via the even bit line BLae. On the other hand, the even bit line BLbe coupling the sense amplifier unit SAUe and the NAND string NSbe goes into a floating state (BLbe: Floating) as the transistors T9b and T10b of the sense amplifier unit SAUe and the select transistor STbe of the NAND string NSbe are in a turned-off state.

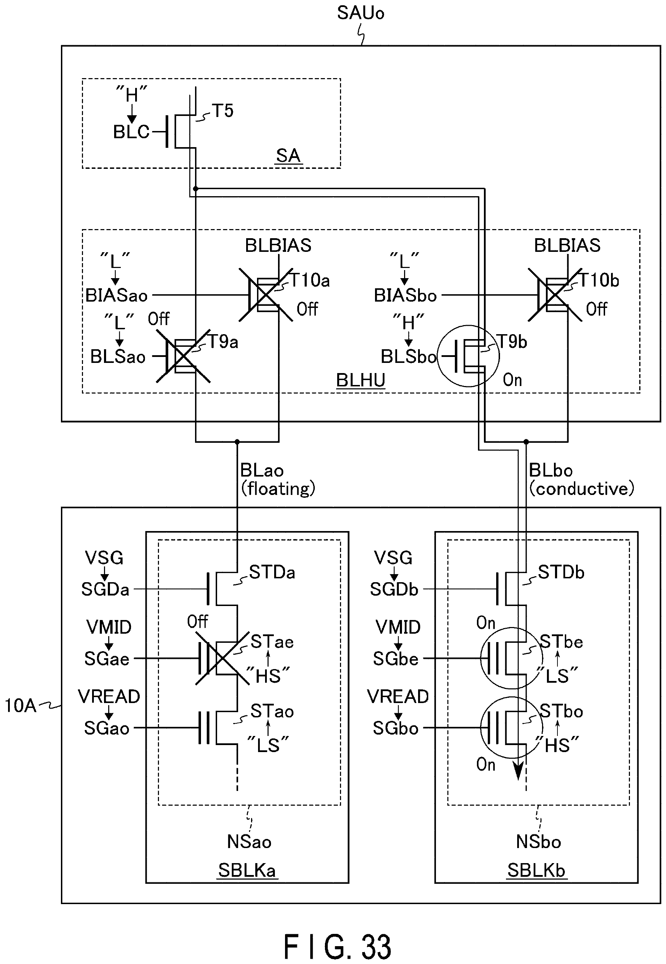

FIG. 33 is a schematic diagram showing an example of a method of selecting a bit line BL in the first read operation of the memory device 1A according to the second embodiment. FIG. 33 shows an operation state of some elements of each of the sense amplifier units SAUo and the NAND strings NSao and NSbo when the first read operation shown in FIG. 31 is executed. As shown in FIG. 33, in the first read operation, the control signal BLC is set to the "H" level, so that the transistor T5 of the sense amplifier unit SAUo is turned on.

In addition, the control signal BLSbo is set to the "H" level, so that the transistor T9b of the sense amplifier unit SAUo is turned on. Each of the control signals BLSao, BIASao, and BIASbo is set to the "L" level, so that the transistors T9a, T10a, and T10b of the sense amplifier unit SAUo are turned off. In the NAND string NSbo, each of the select transistor STbe to which the voltage VMID is applied and the select transistor STbo to which the read path voltage VREAD is applied is turned on. On the other hand, in the NAND string NSao, the select transistor STae to which the voltage VMID is applied is turned off.

As a result, the sense amplifier unit SAUo and the NAND string NSbo are conducted (BLbo: conductive) via the odd bit line BLbo. On the other hand, the odd bit line BLao coupling the sense amplifier unit SAUo and the NAND string NSao goes into a floating state (BLao: Floating) as the transistors T9a and T10a of the sense amplifier unit SAUo and the select transistor STae of the NAND string NSao are in an off state.

As described above, the memory device 1A can read the lower bit data from the memory cell transistor MTsel coupled to the even bit line BLae of the sub-block SBLKa while setting the odd bit line BLao of the sub-block SBLKa in the floating state in the first read operation shown in FIG. 31. In addition, the memory device 1A can read the lower bit data from the memory cell transistor MTsel coupled to the odd bit line BLbo of the sub-block SBLKb while setting the even bit line BLbe of the sub-block SBLKb in the floating state. That is, in the first read operation, the memory device 1A can execute the read operation for the NAND string NSae of the sub-block SBLKa and the read operation for the NAND string NSbo of the sub-block SBLKb in parallel. Therefore, the memory device 1A can collectively read (m+1) -bit data by the first read operation.

Note that the memory device 1A can execute the first read operation similarly to the lower page data by changing the read voltage and the read number in each of the middle page data and the upper page data.

### <2-2-2> Second Read Operation

The second read operation is a read operation in which an odd bit line group (odd bit line BLao) is selected in the sub-block SBLKa and an even bit line group (even bit line BLbe) is selected in the sub-block SBLKb. In the second read operation, the memory device 1A executes an operation similar to the odd bit line read operation for the sub-block SBLKa and executes an operation similar to the even bit line read operation for the sub-block SBLKb. In addition, in the second read operation, similarly to the first read operation, one string unit SU is selected in each of the associated sub-blocks SBLKa and SBLKb.

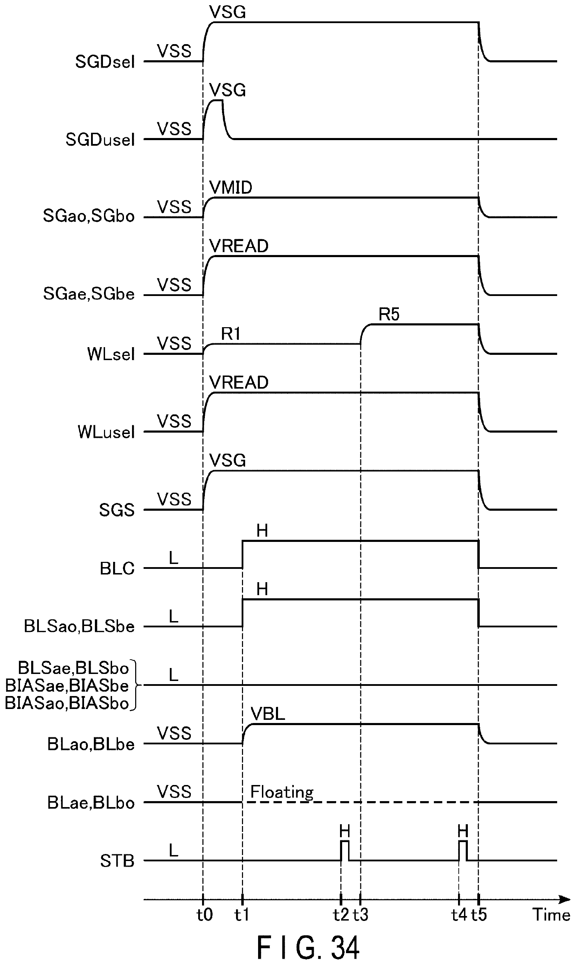

FIG. 34 is a timing chart showing an example of second read operation of the memory device 1A according to the second embodiment. FIG. 34 shows changes in the voltages of the select gate lines SGDsel, SGDusel, SGae, SGbe, SGao and SGbo, the word lines WLsel and WLusel, the select gate lines SGS, the control signals BLC, BLSae, BLSbe, BLSao, BLSbo, BIASae, BIASbe, BIASao, and BIASbo, the bit lines BLae, BLbe, BLao, and BLbo, and the control signal STB in the second read operation for the lower page. As shown in FIG. 34, in the second read operation for the lower page data, the sequencer 14 sequentially executes the processing at times t0 to t5.

The processing from times t0 to t5 in the second read operation is different from the first read operation described with reference to FIG. 31 in the voltage applied to the select gate lines SGae, SGao, SGbe, and SGbo, and in the control method of the control signals BLSae, BLSao, BLSbe, and BLSbo. Specifically, at time t0 of the second read operation, the sequencer 14 applies the voltage VMID to each of the select gate lines SGao and SGbo, and applies the read path voltage VREAD to each of the select gate lines SGae and SGbe. At time t1, the sequencer 14 sets each of the control signals BLSao and BLSbe to the "H" level and sets each of the control signals BLSae, BLSbo, BIASae, BIASbe, BIASao, and BIASbo to the "L" level. By the operation at time t1, the sense amplifier unit SAUo charges the bit line BLao to the voltage VBL, and the sense amplifier unit SAUe charges the bit line BLbe to the voltage VBL. In addition, the bit lines BLae and BLbo goes into a floating state in a period from time t1 to time t5. The other operations of the second read operation are the same as those of the first read operation.

The method of selecting the bit line BL in the second read operation is the same as that when the operation related to the sub-block SBLKa and the operation related to the sub-block SBLKb are replaced with each other in the first read operation. As a result, the memory device 1A can read the lower bit data from the memory cell transistor MTsel coupled to the odd bit line BLao while setting the even bit line BLae for the sub-block SBLKa in the floating state in the second read operation shown in FIG. 34. In addition, the memory device 1A can read the lower bit data from the memory cell transistor MTsel coupled to the even bit line BLbe while setting the odd bit line BLbo for the sub-block SBLKb in the floating state. That is, in the second read operation, the memory device 1A can execute the read operation for the NAND string NSao of the sub-block SBLKa and the read operation for the NAND string NSbe of the sub-block SBLKb in parallel. Therefore, the memory device 1A can collectively read (m+1) -bit data by the second read operation.

Note that the memory device 1A can execute the second read operation similarly to the lower page data by changing the read voltage and the read number in each of the middle page data and the upper page data.

### <2-2-3> Shield Read Operation

The shield read operation is a read operation executed in a state where the shield voltage is applied to the unselected bit line BL, and can be executed by selecting the bit line BL similarly to the first read operation or the second read operation. Hereinafter, a case where the bit line BL is selected in the shield read operation for the lower page similarly to the first read operation will be described.

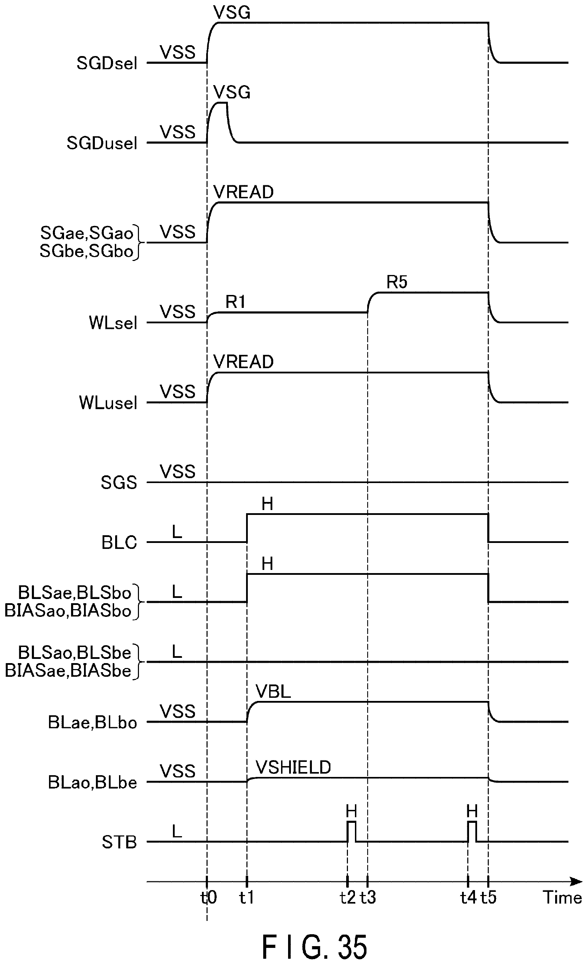

FIG. 35 is a timing chart showing an example of shield read operation of the memory device 1A according to the second embodiment. FIG. 35 shows changes in the voltages of the select gate lines SGDsel and SGDusel, the select gate lines SGae, SGbe, SGao and SGbo, the word lines WLsel and WLusel, the select gate lines SGS, the control signals BLC, BLSae, BLSbe, BLSao, BLSbo, BIASae, BIASbe, BIASao, and BIASbo, the bit lines BLae, BLbe, BLao, and BLbo, and the control signal STB in the shield read operation for the lower page. As shown in FIG. 35, in the shield read operation for the lower page data, the sequencer 14 sequentially executes the processing at times t0 to t5.

The processing from times t0 to t5 in the shield read operation is different from the first read operation described with reference to FIG. 31 in the voltage of the select gate lines SGae, SGao, SGbe and SGbo, in the control method of sets of control signals BLSae, BLSao, BLSbe, BLSbo, BIASae, BIASbe, BIASao, and BIASbo, and in the voltage of the bit lines BLao and BLbe. Specifically, at time t0 of the shield read operation, the sequencer 14 applies the read path voltage VREAD to each of the select gate lines SGae, SGao, SGbe and SGbo. At time t1 of the shield read operation, the sequencer 14 sets each of the control signals BLSae, BLSbo, BIASao and BIASbo to the "H" level and sets each of the control signals BLSao, BLSbe, BIASae and BIASbe to the "L" level. By the operation at time t1, each of the bit lines BLae and BLbo is charged to the voltage VBL. In addition, a shield voltage VSHIELD is applied to each of the bit lines BLae and BLbo based on the voltage of the node BLBIAS. The shield voltage VSHIELD corresponds to, for example, the potential of the source line SL. The other operations of the shield read operation are the same as those of the first read operation.

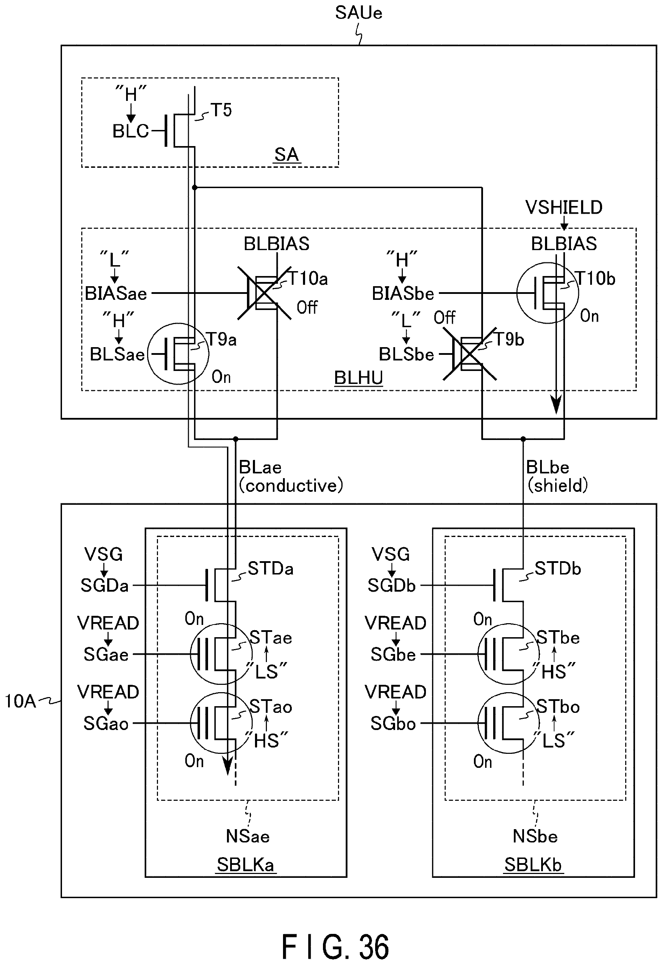

FIG. 36 is a schematic diagram illustrating an example of a method of selecting a bit line BL in the shield read operation of the memory device 1A according to the second embodiment. FIG. 36 shows an operation state of some elements of each of the sense amplifier units SAUe and the NAND strings NSae and NSbe when the shield read operation shown in FIG. 35 is executed. As shown in FIG. 36, the shield read operation in the present example is different from the first read operation described with reference to FIG. 32 in that the control signal BIASbe is at the "H" level. As a result, the transistor T10b of the sense amplifier unit SAUe is turned on. As a result, the voltage (shield voltage VSHIELD) at the node BLBIAS is applied to the even bit line BLbe via the transistor T10b (BLbe: shield). On the other hand, in the sense amplifier unit SAUo, the voltage (shield voltage VSHIELD) at the node BLBIAS is applied to the odd bit line BLao via the transistor T10a (not shown).

As a result, the memory device 1A can read the lower bit data from the memory cell transistor MTsel coupled to the even bit line BLae while shielding the odd bit line BLao for the sub-block SBLKa in the shield read operation shown in FIG. 35. In addition, the memory device 1A can read the lower bit data from the memory cell transistor MTsel coupled to the odd bit line BLbo while shielding the even bit line BLbe for the sub-block SBLKb.

In the shield read operation for the lower page, the operation when the bit line BL is selected similarly to the second read operation is the same as that when the operation related to the sub-block SBLKa and the operation related to the sub-block SBLKb are replaced with each other in the shield read operation described above. The memory device 1A can execute the shield read operation similarly to the lower page data by changing the read voltage and the read number in each of the middle page data and the upper page data. Further, in the shield read operation, the select gate lines SGae, SGao, SGbe, and SGbo may be controlled similarly to the first read operation and the second read operation.

### <2-2-4> Write Operation

Hereinafter, a write operation of the memory device 1A will be described.

### (1: Outline of Write Operation)

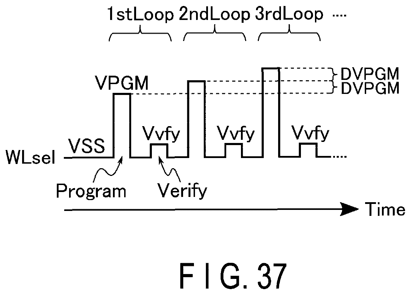

FIG. 37 is a timing chart showing an outline of write operation of the memory device 1A according to the second embodiment. FIG. 37 shows a change in the voltage of the word line WLsel in the write operation. As shown in FIG. 37, the memory device 1A executes loop processing (program loop processing) including a program operation and a verify operation in the write operation. Although FIG. 37 shows the loop processing performed 3 times (1st Loop, 2nd Loop, 3rd Loop), the number of times of the loop processing may vary depending on the setting of the write operation and the like.

The program operation is an operation capable of increasing the threshold voltage of the memory cell transistor MTsel. The sequencer 14 sets each memory cell transistor MTsel to be programmed or to be program-prohibited, and executes the program operation. The memory cell transistor MTsel to be programmed is the memory cell transistor MTsel that has not reached the threshold voltage of the state (hereinafter, referred to as a "target state") corresponding to the data to be written. The program-prohibited memory cell transistor MTsel is the memory cell transistor MTsel that has reached the threshold voltage of the target state.

In the program operation, the sequencer 14 applies the program voltage VPGM to the word line WLsel. The VPGM is a high voltage capable of increasing the threshold voltage of the memory cell transistor MTsel. Then, in the program-target memory cell transistor MTsel, electrons are injected into the charge storage layer based on the voltage difference between the word line WLsel and the channel, and the threshold voltage increases. On the other hand, in the program-prohibited memory cell transistor MTsel, the channel potential is boosted by cutoff of the select transistor STD, and an increase in the threshold voltage is suppressed.

The verify operation is a read operation of confirming whether or not the threshold voltage of the memory cell transistor MTsel has reached the threshold voltage of the target state. In the verify operation, the read operation using the verify voltage Vvfy is executed. In this example, the verify voltage Vvfy is any one of the verify voltages VS1, VS2, VS3, VS4, VS5, VS6, and VS7. In the verify operation, when it can be considered that the threshold voltage of the memory cell transistor MTsel exceeds the verify voltage Vvfy, it is determined as "verify pass". On the other hand, when it can be considered that the threshold voltage of the memory cell transistor MTsel is equal to or less than the verify voltage Vvfy, it is determined as "verify fail".

When the verify operation is ended, the sequencer 14 sets the memory cell transistor MTsel in which the threshold voltage has reached the target state to be program-prohibited based on the result of the verify read in the current loop processing. Thereafter, the sequencer 14 starts the next loop processing. The value of the program voltage VPGM is stepped up according to the repetition of the loop processing. In FIG. 31, the voltage difference corresponding to the step-up width of the VPGM for each loop processing is shown as a DVPGM. In each loop processing, a read operation using a plurality of verify voltages may be executed.

In addition, the memory device 1A can execute the detection operation after each loop processing. In the detection operation, the number of memory cell transistors MTsel that have passed verification is counted for each state. Then, the sequencer 14 determines whether writing has been completed for each state. The completion of the writing is determined, for example, based on the fact that the number of memory cell transistors MTsel in the verify-fail state has fallen below a predetermined number. In the repetition of the loop processing, for example, when detecting that the writing of each of the "S1" to "S7" states is completed, the sequencer 14 ends the write operation.

### (2: Program Operation)

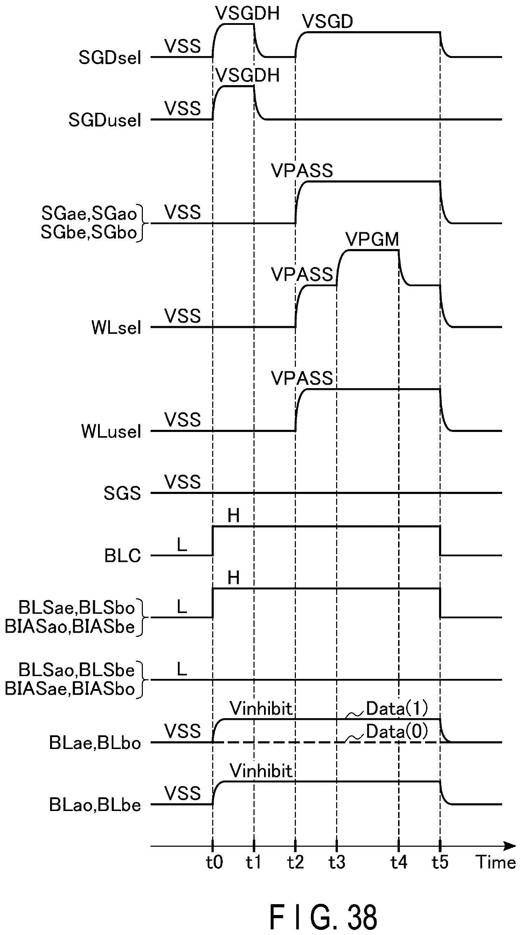

FIG. 38 is a timing chart showing an example of program operation of the write operation of the memory device 1A according to the second embodiment. FIG. 38 shows a case where the program operation for the NAND string NSae by the sense amplifier unit SAUe and the program operation for the NAND string NSbo by the sense amplifier unit SAUo are executed in parallel. FIG. 38 shows changes in the voltages of the select gate lines SGDsel, SGDusel, SGae, SGao, SGbe and SGbo, the word lines WLsel and WLusel, the select gate lines SGS, the control signals BLC, BLSae, BLSbe, BLSao, BLSbo, BIASae, BIASbe, BIASao, and BIASbo, and the bit lines BLae, BLbe, BLao, and BLbo in the program operation. As shown in FIG. 38, in the program operation, the sequencer 14 sequentially executes processing at times t0 to t5.

At the start of the program operation, the voltage applied to each wiring is the ground voltage VSS, and each control signal is at the "L" level.

At time t0, the sequencer 14 applies the voltage VSGDH to each of the select gate lines SGDsel and SGDusel, and sets each of the control signals BLC, BLSae, BLSbo, BIASao, and BIASbe to the "H" level. Then, the voltage Vinhibit is applied to each of the bit lines BLao and BLbe. In addition, the ground voltage VSS is applied to the program-target bit line BLae, and the voltage Vinhibit is applied to the program-prohibited bit line BLae. Similarly, the ground voltage VSS is applied to the program-target bit line BLbo, and the voltage Vinhibit is applied to the program-prohibited bit line BLbo. Each select transistor STD is turned on by application of the voltage VSGDH.

At time t1, the sequencer 14 applies the ground voltage VSS to each of the select gate lines SGDsel and SGDusel. Then, each select transistor STD of the selected block BLK is turned off. At this time, the channel voltage of the NAND string NS coupled to the program-target bit line BL is, for example, the ground voltage VSS. On the other hand, the channel voltage of the NAND string NS coupled to the program-prohibited bit line BL is maintained in an increased state based on the voltage Vinhibit.

At time t2, the sequencer 14 applies the voltage VSGD to the select gate line SGDsel, and applies the write path voltage VPASS to each of the word lines WLsel and WLusel. The voltage VSGD is higher than the ground voltage VSS and lower than the voltage VSGDH. The write path voltage VPASS is higher than the voltage VSGDH. At this time, the select transistor STD coupled to the program-target bit line BL is turned on. On the other hand, the select transistor STD coupled to the program-prohibited bit line BL is turned off, and the channel voltage of the NAND string NS that has gone into the floating state increases due to coupling with the word lines WLsel and WLusel.

At time t3, the sequencer 14 applies the program voltage VPGM to the word line WLsel. When the program voltage VPGM is applied to the word line WLsel, in the program-target memory cell transistor MTsel, electrons are injected into the charge storage layer based on the voltage difference between the channel and the control gate, and the threshold voltage increases. On the other hand, an increase in the threshold voltage of the memory cell transistor MT in the other NAND strings NS is suppressed by an increase (self-boost) in the channel voltage.

At time t4, the sequencer 14 lowers the voltage of the word line WLsel to the write path voltage VPASS.

At time t5, the sequencer 14 transitions the voltage applied to each wiring and the voltage of each control signal to the state at the start of the even/odd bit line read operation. Thereafter, the memory device 1A ends the program operation.

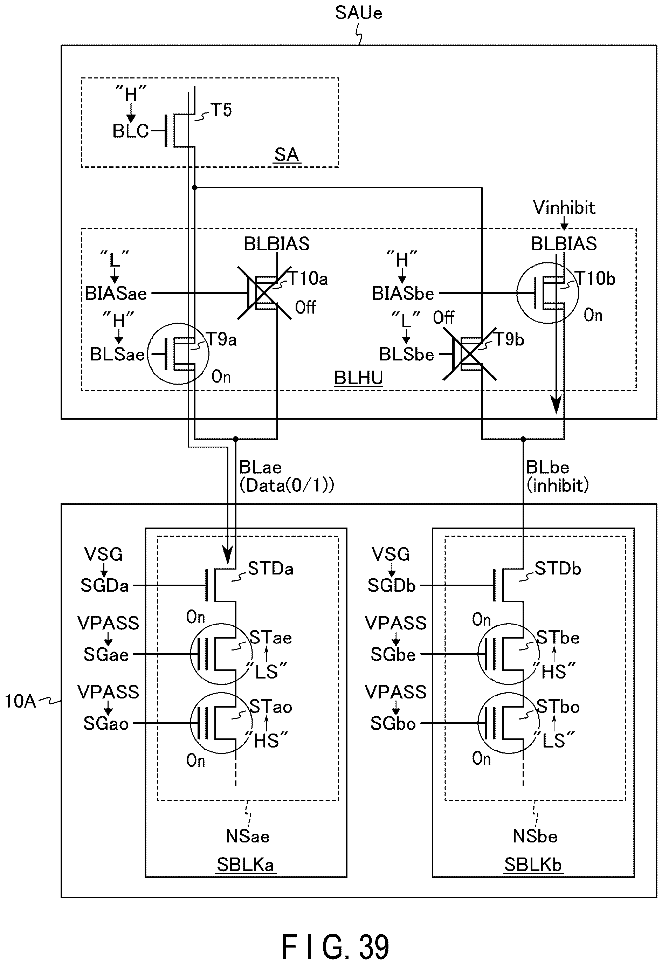

FIG. 39 is a schematic diagram showing an example of a method of selecting a bit line BL in the program operation of the write operation of the memory device 1A according to the second embodiment. FIG. 39 shows an operation state of some elements of each of the sense amplifier units SAUe and the NAND strings NSae and NSbe when the program operation shown in FIG. 38 is executed. As shown in FIG. 39, in the program operation, the control signal BLC is set to the "H" level, so that the transistor T5 of the sense amplifier unit SAUe is turned on.

When the control signals BLSae and BLSbe are set to the "H" level and the "L" level, respectively, the transistors T9a and T9b of the sense amplifier unit SAUo are turned on and off, respectively. When the control signals BIASae and BIASbe are set to the "L" level and the "H" level, respectively, the transistors T10a and T10b of the sense amplifier unit SAUe are turned off and turned on, respectively. In each of the NAND strings NSae and NSbe, each of the select transistors STae, STao, STbe, and STbo to which the write path voltage VPASS is applied is turned on. As a result, the even bit line BLae is charged according to the write data via the transistor T9a (BLae: (Data (0/1)). In addition, the even bit line BLbe is charged according to the voltage of the node BLBIAS via the transistor T10b (BLbe: inhibit).

As a result, the sense amplifier unit SAUe can execute a program operation for one of the sub-blocks SBLKa and SBLKb. Similarly, the sense amplifier unit SAUo can execute a program operation for one of the sub-blocks SBLKa and SBLKb (not shown). That is, the memory device 1A can execute a program operation for the NAND string NSae of the sub-block SBLKa and a program operation for the NAND string NSbo of the sub-block SBLKb in parallel. Further, the memory device 1A can execute a program operation for the NAND string NSbe of the sub-block SBLKa and a program operation for the NAND string NSao of the sub-block SBLKb in parallel. Therefore, the memory device 1A can collectively program (m+1) -bit data.

### (3: Verify Operation)

As the verify operation of the memory device 1A according to the second embodiment, either the first read operation or the second read operation is executed according to the address. In addition, as the verify operation of the memory device 1A, a shield read operation may be executed.

### <2-3> Advantageous Effects of Second Embodiment

A memory device having a structure in which a memory cell array 10 (sub array 101) is stacked is known. In such a memory device, the word line WL is shared by the upper and lower sub-blocks SBLKa and SBLKb in order to suppress the transistor TR that increases with an increase in the number of stacked word lines WL and the step width in the hookup region HR. Then, a configuration is considered in which the bit line BL of 16KB is provided in each of the sub arrays 101a and 101b, and the bit line BL of 16KB of each of the sub arrays 101a and 101b is coupled to the sense amplifier unit SAU for 16KB.

Then, the memory device 1A according to the second embodiment reads 8KB page data from the sub array 101a, reads 8KB page data from the sub array 101b, and executes read operations (first read operation and second read operation) capable of collectively reading data of 16KB in total. That is, the memory device 1A can execute the read operation in a state in which the apparent capacity of the bit line BL is halved by setting every other bit line BL to the floating state while realizing the 16KB page read.

As a result, the memory device 1A according to the second embodiment can improve the speed of the read operation and shorten the operation time.

Furthermore, the memory device 1A according to the second embodiment can realize the 16KB page read in the shield read operation by setting every other bit line BL in the shield state (for example, a state in which a source line potential is applied). The shield read operation can improve the precharge speed and the like of the bit line BL as compared with the case of using the floating state. Therefore, the memory device 1A according to the second embodiment can be operated with the same sense amplifier unit SAU of 16KB same as conventional, and can realize 16KB page read with a shortened operation time without increasing the circuit area. For example, in Power on Read (POR), the startup time of the memory device 1A can be shortened by using shield reading of 16KB page data instead of the shield reading operation of 8KB. In addition, in the case of the shield reading, since the current does not flow, the power consumption of the memory device 1A can be suppressed.

The method of reading 8KB page data from each of the sub arrays 101a and 101b may be used in the verify operation during the write operation. Even in such a case, the speed of the verify operation can be improved similarly to the read operation. Also during the program operation, the precharge time and the stabilization time of the bit line BL can be shortened. Therefore, the memory device 1A according to the second embodiment can shorten not only the operation time of the read operation and the verify operation but also the operation time of the program operation.

### <3> Further embodiments, etc.

Further embodiments etc. of the memory device 1 described in connection with the above embodiments will be described below.

In the first embodiment, the case where the read path voltage VREAD is used as the voltage for turning on the select transistors SGe and SGo has been exemplified, but the present invention is not limited thereto. As long as each of the select transistors STe and STo can be turned on, a voltage different from the read path voltage VREAD may be used. Similarly, in the second embodiment, the case where the read path voltage VREAD is used as the voltage for turning on the select transistors STae, STao, STbe, and STbo has been exemplified, but the present invention is not limited thereto. As long as each of the select transistors STae, STao, STbe and STbo can be turned on, a voltage different from the read path voltage VREAD may be used.

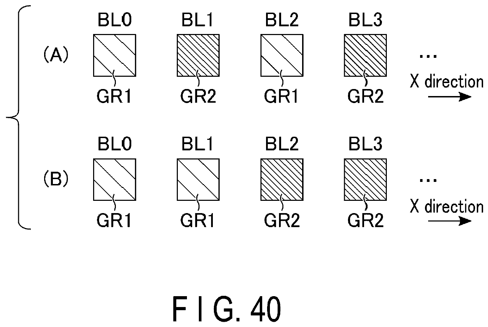

FIG. 40 is a schematic diagram showing a further embodiment of allocation of groups of bit lines BL. (A) of FIG. 40 corresponds to the grouping of the bit lines BL described in the first embodiment. Specifically, the plurality of bit lines BL are classified into an even bit line group (group GR1) including the even bit line BLe(BL0, BL2,...) and an odd bit line group (group GR2) including the odd bit line BLo(BL1, BL3,...). In the grouping of the bit lines BL (A) of FIG. 40, the capacitance of the bit lines BL is substantially halved.

On the other hand, as shown in (B) of FIG. 40, the grouping of the bit lines BL may be changed. Specifically, a plurality of sets of two bit lines BL adjacent in the X direction are arranged in the X direction. Then, a plurality of sets of the two bit lines BL are classified into a group GR1 including an even set and a group GR2 including an odd set. Even in such a case, the memory device 1 can reduce the bit line capacity and shorten the operation time. Since the capacitance of the bit line BL strongly depends on the capacitance component of the adjacent bit line BL, it is more preferable that the bit line BL set in the floating state and the bit line BL to be operated are adjacent to each other. This further embodiment may be combined with the second embodiment. It suffices that in the memory device 1A, a pair of the bit lines BLa and BLb coupled to the same sense amplifier unit SAU is configured to be included in different groups.

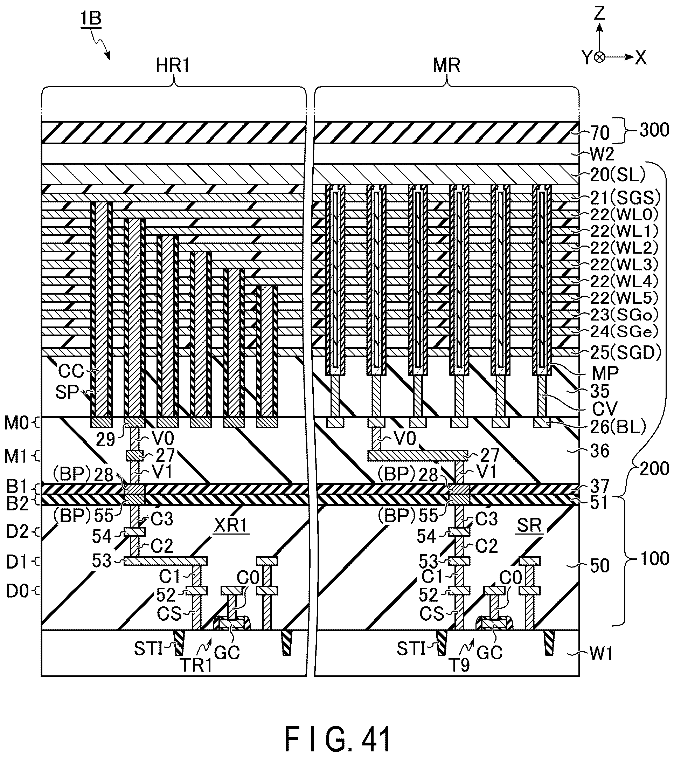

FIG. 41 is a cross-sectional view illustrating a further embodiment of the structure of the memory device 1. FIG. 41 shows a region same as that shown in FIG. 14 described in connection with the first embodiment. In the further embodiment shown in FIG. 41, each of the conductive layers 21 to 25 does not have a terrace portion. In this case, each of the conductive layers 21 to 25 is provided in a plate shape in each of the hookup regions HR1 and HR2. Each contact CC in the further embodiment penetrates the conductive layer between the wiring layer M0 and the conductive layer to which it is coupled. A spacer SP is provided on the side surface of each contact CC. Thus, each contact CC of the further embodiment can function similarly to the contact CC of the first embodiment. As described above, even if a hookup region HR is not provided with terrace portions, it suffices that the memory device 1 is designed to have a structure in which a set of wirings associated with certain contacts CC are electrically coupled to other stacked wirings without being shortcircuited. This further embodiment may be combined with the second embodiment.

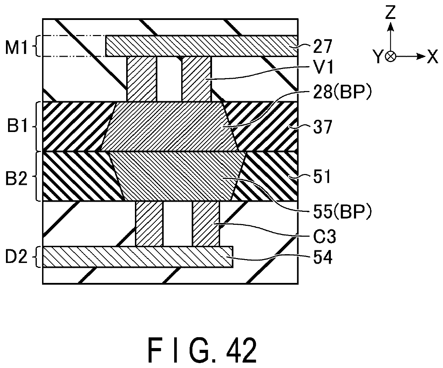

FIG. 42 is a cross-sectional view showing an example of a detailed cross-sectional structure of the joint portion of bonding pads BP. FIG. 42 shows a conductive layer 55 (bonding pad BP) of the CMOS layer 100, a conductive layer 28 (bonding pad BP) of the memory layer 200, and some contacts and wirings coupled to these bonding pads BP. As shown in FIG. 42, two bonding pads BP arranged opposite to each other can have different tapered shapes, based on the etching directions at the time of formation. Specifically, the conductive layer 55 formed using the first substrate W1 has, for example, a reverse tapered shape that becomes thinner toward the substrate W1. The conductive layer 28 formed using the second substrate W2 has, for example, a tapered shape that becomes thicker toward the substrate W1. The pair of bonding pads BP opposed to each other may be shifted when they are bonded, depending on the alignment during the bonding process. Therefore, a step may be formed between the upper surface of the conductive layer 55 and the lower surface of the conductive layer 28. The pair of bonding pads BP opposed to each other may have a boundary therebetween or may be integrated as one piece. The bonding pad BP and the contact coupled to the bonding pad BP may be integrally formed as one piece. The conductive layer 55 may be coupled to the conductive layer 54 via a plurality of contacts C3. Similarly, the conductive layer 28 may be coupled to the conductive layer 27 via a plurality of contacts V1.

In connection with the above embodiments, an example was given of the case where the memory layer 200 is provided above the CMOS layer 100, but the CMOS layer 100 may be provided above the memory layer 200. In this case, for example, a wiring layer 300 (pad PD) is provided on the CMOS layer 100.

In the above embodiments, the circuit configuration, planar layout, and cross-sectional structure of the memory device 1 can be changed as appropriate. For example, the semiconductor layer 41 of the memory pillar MP and the source line SL may be coupled via the side surface of the memory pillar MP. The memory pillar MP may have a structure in which two or more pillars are coupled in the Z direction. The memory pillar MP may have a structure in which a pillar corresponding to the select gate line SGD and a pillar corresponding to the word line WL are coupled to each other. Each contact may be coupled using a plurality of contacts linked in the Z direction. A conductive layer may be inserted between the coupling portions of the plurality of contacts. The number of wiring layers and contacts included in the memory device 1 can be changed as appropriate.

The drawings referred to in connection with the above embodiments show a case where the memory pillars MP have the same diameter as viewed in the Z direction, but this is not restrictive. The memory pillars MP may have a tapered shape, a reverse tapered shape, or a bowing shape. Similarly, each of the slits SLT and SHE may have a tapered shape, a reverse tapered shape, or a bowing shape. Further, each contact may have a tapered shape, a reverse tapered shape, or a bowing shape. The cross-sectional structure of each of the memory pillars MP and the contacts V0 to V3, CC and C3 may be circular or elliptical.

In the present specification, the term "coupling" means that elements are electrically coupled, and does not exclude the case where another element is interposed in between. "Electrically coupled" may be via an insulator as long as it can operate in the same manner as electrically coupled. The "tapered shape" indicates a shape whose thickness decreases as the distance from the reference substrate increases. The "reverse tapered shape" indicates a shape whose thickness increases as the distance from the reference substrate increases. The "columnar" indicates that the related structure is provided in a hole formed in the manufacturing process of the memory device 1. The "semiconductor layer" may be referred to as a "conductive layer". The word line WL, the select gate lines SGD, SGS, SGe, SGo, and the like may be simply referred to as "wiring".

In the present specification, even and odd referenced components are not necessarily the arranged components at the ends. Any component can be used as the even and odd references. In the present specification, the NAND string NS may be referred to as a "string". The NAND string NS coupled to the even bit line BLe may be referred to as an "even string". The NAND string NS coupled to the odd bit line BLo may be referred to as an "odd string". The voltage at the "H" level is a logic level at which the N-type transistor to which the voltage at the level is applied to the gate is turned on. The voltage at the "L" level is a logic level at which the N-type transistor to which the voltage at the level is applied to the gate is turned off.

In the present specification, applying a voltage to the word line WL corresponds to the driver circuit 15 applying a voltage to the word line WL via the row decoder module 16. Similarly to the word line WL, the application of the voltage to the other stacked wirings corresponds to the application of the voltage to the driver circuit 15 via the row decoder module 16. The voltage of the stacked wiring may be estimated based on the voltage of the signal line coupling the driver circuit 15 and the row decoder module 16. A "region" used in the present specification may be considered a feature provided by a reference substrate. For example, where the first substrate W1 is defined to include the memory region MR and the hookup region HR, the memory region MR and the hookup region HR are associated with different regions above the first substrate W1.

Some or all of the embodiments described above can be described as in the following supplementary notes, but is not limited thereto:
[Supplementary Note 1]
   a plurality of bit lines (BL);
   a plurality of strings (NS) each having one end coupled to the bit lines, each of the strings including a memory cell (MT), a first transistor (STe), and a second transistor (STo) coupled in series;
   a first wiring (SGe) coupled to the first transistor of each of the strings;
   a second wiring (SGo) coupled to the second transistor of each of the strings;
   a word line coupled to the memory cell of each of the strings; and
   a sequencer, wherein
   the sequencer is configured to:
      in a read operation of N (N is an integer equal to or larger than 1) bytes in which the word line is selected, apply a first voltage (VMID) to one of the first wiring line and the second wiring line, and apply a second voltage (VREAD) higher than the first voltage to the other of the first wiring line and the second wiring line; and
      in a read operation of 2×N bytes in which the word line is selected, apply a third voltage (VREAD) higher than the first voltage to each of the first wiring and the second wiring.
[Supplementary Note 2]
   The memory device of Supplementary Note 1, further comprising:
   sense amplifier units respectively coupled to the bit lines, the sense amplifier units being configured to be able to determine data, wherein
   each of the sense amplifier units includes a third transistor coupled to any of the bit lines, and
   the sequencer is further configured to:
      in a read operation of N bytes in which the word line is selected, control to turn on the third transistors of the number included in the sense amplifier units and corresponding to N bytes, and control to turn off the remaining third transistors; and
      in a read operation of 2×N bytes in which the word line is selected, control to turn on the third transistors of the number included in the sense amplifier units and corresponding to 2×N bytes.
[Supplementary Note 3]
   The memory device of Supplementary Note 2, wherein
   the read operation of N bytes has first and second modes, and
   the sequencer is further configured to
   in the first mode, apply the first voltage and the second voltage to the first wiring and the second wiring, respectively, and
   in the second mode, apply the second voltage and the first voltage to the first wiring and the second wiring, respectively.
[Supplementary Note 4]
   The memory device of Supplementary Note 3, wherein
   in the read operation of N bytes, the sequencer is further configured to:
   in the case of the first mode, control to turn on the third transistor coupled to an even bit line included in the bit lines, and
   in the case of the second mode, control to turn on the third transistor coupled to an odd bit line included in the bit lines.
[Supplementary Note 5]
   The memory device of Supplementary Note 3, wherein
   in an even string coupled to the even bit line among the strings, a threshold voltage of the first transistor is lower than a threshold voltage of the second transistor, and
   in an odd string coupled to the odd bit line among the strings, a threshold voltage of the first transistor is higher than a threshold voltage of the second transistor.
[Supplementary Note 6]
   The memory device of Supplementary Note 1, wherein
   the first voltage is between a threshold voltage of the first transistor and a threshold voltage of the second transistor in the even string, and between a threshold voltage of the first transistor and a threshold voltage of the second transistor in the odd string, and
   the second voltage is higher than a threshold voltage of the second transistor in the even string and higher than a threshold voltage of the first transistor in the odd string.
[Supplementary Note 7]
   The memory device of Supplementary Note 1, further comprising:
   a substrate, wherein
   in each of the strings, the first transistor, the second transistor, and the memory cell are arranged in a direction intersecting a surface of the substrate.
[Supplementary Note 8]
   The memory device of Supplementary Note 1, wherein
   the second voltage is substantially equal to the third voltage.
[Supplementary Note 9]
   A memory device comprising:
   a CMOS layer (100), a first memory layer (200a), and a second memory layer (200b) stacked in a first direction; and
   sequencer, wherein
   the first memory layer includes a plurality of first bit lines (BLa) and a plurality of first strings (NSa), and one end of each of the first strings is coupled to each of the first bit lines,
   the second memory layer includes a plurality of second bit lines (BLb) and a plurality of second strings (NSb), and one end of each of the second strings is coupled to each of the second bit lines,
   the CMOS layer includes a plurality of sense amplifier units (SAU) configured to be able to determine data, the sense amplifier units are respectively coupled to the first bit lines and are respectively coupled to the second bit lines, each of the sense amplifier units includes a first transistor (T9a) coupled to any of the first bit lines, a second transistor (T9b) coupled to any of the second bit lines, and a sense node (SEN) coupled to each of the first transistor and the second transistor, and the sense amplifier units includes a plurality of first sense amplifier units and a plurality of second sense amplifier units,
   in the read operation, the sequencer is configured to:
      apply a voltage of a first logic level ("H") to the first transistor of each of the first sense amplifier units, and apply a voltage of a second logic level ("L") different from the first logic level to the second transistor of each of the first sense amplifier units, and
      apply a voltage of the second logic level to the first transistor of each of the second sense amplifier units, and apply a voltage of the first logic level to the second transistor of each of the second sense amplifier units.
[Supplementary Note 10]
   The memory device of Supplementary Note 9, wherein
   the sequencer is further configured to:
   in the first read operation, control to turn on each of the first transistor of the first sense amplifier unit and the second transistor of the second sense amplifier unit, and control to turn off each of the second transistor of the first sense amplifier unit and the first transistor of the second sense amplifier unit, and
   in the second read operation, control to turn on each of the second transistor of the first sense amplifier unit and the first transistor of the second sense amplifier unit, and control to turn off each of the first transistor of the first sense amplifier unit and the second transistor of the second sense amplifier unit.
[Supplementary Note 11]
   The memory device of Supplementary Note 9, wherein
   each of the first strings includes a first memory cell (MTa), a third transistor (STae), and a fourth transistor (STao) coupled in series, the first memory layer further includes a first wiring (SGae), a second wiring (SGao), and a first word line (WL/22a), the first wiring is coupled to the third transistor of each of the first strings, the second wiring is coupled to the fourth transistor of each of the first strings, and the first word line is coupled to the first memory cell of each of the first strings,
   each of the second strings includes a second memory cell (MTb), a fifth transistor (STbe), and a sixth transistor (STbo) coupled in series, the second memory layer further includes a third wiring (SGbe), a fourth wiring (SGbo), and a second word line (WL/22b), the third wiring is coupled to the fifth transistor of each of the second strings, the fourth wiring is coupled to the sixth transistor of each of the second strings, and the second word line is coupled to the second memory cell of each of the second strings and is electrically coupled to the first word line, and
   the sequencer is further configured to
   in a first read operation in which the first and second word lines are selected, apply a first voltage (VMID) to the first wiring, apply a second voltage (VREAD) higher than the first voltage to the second wiring, apply the first voltage to the third wiring, and apply the second voltage to the fourth wiring.
[Supplementary Note 12]
   The memory device of Supplementary Note 11, wherein
   the sequencer is further configured to
   in a second read operation in which the first and second word lines are selected, apply the second voltage to the first wiring, apply the first voltage to the second wiring, apply the second voltage to the third wiring, and apply the first voltage to the fourth wiring.
[Supplementary Note 13]
   in an even first string (NSae) coupled to an even first bit line (BLae) among the first strings, a threshold voltage of the third transistor is lower than a threshold voltage of the fourth transistor,
   in an odd first string (NSao) coupled to an odd first bit line (BLao) among the first strings, a threshold voltage of the third transistor is higher than a threshold voltage of the fourth transistor,
   in an even second string (NSbe) coupled to an even second bit line (BLbe) among the second strings, a threshold voltage of the fifth transistor is higher than a threshold voltage of the sixth transistor, and
   in an odd second string (NSbo) coupled to an odd second bit line (BLbo) among the second strings, a threshold voltage of the fifth transistor is lower than a threshold voltage of the sixth transistor.
[Supplementary Note 14]
   The memory device of Supplementary Note 13, wherein
   the first voltage is between a threshold voltage of the third transistor and a threshold voltage of the fourth transistor in the even first string, between a threshold voltage of the third transistor and a threshold voltage of the fourth transistor in the first odd string, between a threshold voltage of the fifth transistor and a threshold voltage of the sixth transistor in the second even string, and between a threshold voltage of the fifth transistor and a threshold voltage of the sixth transistor in the second odd string, and
   the second voltage is higher than a threshold voltage of the fourth transistor in the even first string, higher than a threshold voltage of the third transistor in the odd first string, higher than a threshold voltage of the fifth transistor in the even second string, and higher than a threshold voltage of the sixth transistor in the odd second string.
[Supplementary Note 15]
   The memory device of Supplementary Note 9, wherein
   each of the sense amplifier units includes a seventh transistor (T10a) coupled to any of the first bit lines, an eighth transistor (T10b) coupled to any of the second bit lines, and a first node coupled to each of the seventh transistor and the eighth transistor, and
   in the read operation, the sequencer is configured to
   apply a voltage of the second logic level to each of the seventh transistor and the eighth transistor of each of the sense amplifier units.
[Supplementary Note 16]
   The memory device of Supplementary Note 9, wherein
   each of the sense amplifier units includes a seventh transistor (T10a) coupled to any of the first bit lines, an eighth transistor (T10b) coupled to any of the second bit lines, and a first node coupled to each of the seventh transistor and the eighth transistor, and
   in the read operation, the sequencer is configured to
   apply a voltage of the first logic level to each of the seventh transistor and the eighth transistor of each of the sense amplifier units, and apply a third voltage to the first node.

Although some embodiments of the present invention have been described, these embodiments have been presented as examples, and are not intended to limit the scope of the invention. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or further embodiments as would fall within the scope and spirit of the inventions.

## Claims

1. A memory device comprising:
a plurality of bit lines (BL);
a plurality of strings (NS) each having one end coupled to the bit lines, each of the strings including a memory cell (MT), a first transistor (STe), and a second transistor (STo) coupled in series;
a first wiring (SGe) coupled to the first transistor of each of the strings;
a second wiring (SGo) coupled to the second transistor of each of the strings;
a word line coupled to the memory cell of each of the strings; and
a sequencer, wherein
the sequencer is configured to:
in a read operation of N (N is an integer equal to or larger than 1) bytes in which the word line is selected, apply a first voltage (VMID) to one of the first wiring line and the second wiring line, and apply a second voltage (VREAD) higher than the first voltage to the other of the first wiring line and the second wiring line; and
in a read operation of 2×N bytes in which the word line is selected, apply a third voltage (VREAD) higher than the first voltage to each of the first wiring and the second wiring.

2. The memory device of claim 1, further comprising:
sense amplifier units respectively coupled to the bit lines, the sense amplifier units being configured to be able to determine data, wherein
each of the sense amplifier units includes a third transistor coupled to any of the bit lines, and
the sequencer is further configured to:
in a read operation of N bytes in which the word line is selected, control to turn on the third transistors of the number included in the sense amplifier units and corresponding to N bytes, and control to turn off the remaining third transistors; and
in a read operation of 2×N bytes in which the word line is selected, control to turn on the third transistors of the number included in the sense amplifier units and corresponding to 2×N bytes.

3. The memory device of claim 2, wherein
the read operation of N bytes has first and second modes, and
the sequencer is further configured to
in the first mode, apply the first voltage and the second voltage to the first wiring and the second wiring, respectively, and
in the second mode, apply the second voltage and the first voltage to the first wiring and the second wiring, respectively.

4. The memory device of claim 3, wherein
in the read operation of N bytes, the sequencer is further configured to:
in the case of the first mode, control to turn on the third transistor coupled to an even bit line included in the bit lines, and
in the case of the second mode, control to turn on the third transistor coupled to an odd bit line included in the bit lines.

5. The memory device of claim 3, wherein
in an even string coupled to the even bit line among the strings, a threshold voltage of the first transistor is lower than a threshold voltage of the second transistor, and
in an odd string coupled to the odd bit line among the strings, a threshold voltage of the first transistor is higher than a threshold voltage of the second transistor.

6. The memory device of claim 1, wherein
the first voltage is between a threshold voltage of the first transistor and a threshold voltage of the second transistor in the even string, and between a threshold voltage of the first transistor and a threshold voltage of the second transistor in the odd string, and
the second voltage is higher than a threshold voltage of the second transistor in the even string and higher than a threshold voltage of the first transistor in the odd string.

7. The memory device of claim 1, further comprising:
a substrate, wherein
in each of the strings, the first transistor, the second transistor, and the memory cell are arranged in a direction intersecting a surface of the substrate.

8. The memory device of claim 1, wherein
the second voltage is substantially equal to the third voltage.

9. A memory device comprising:
a CMOS layer (100), a first memory layer (200a), and a second memory layer (200b) stacked in a first direction; and
sequencer, wherein
the first memory layer includes a plurality of first bit lines (BLa) and a plurality of first strings (NSa), and one end of each of the first strings is coupled to each of the first bit lines,
the second memory layer includes a plurality of second bit lines (BLb) and a plurality of second strings (NSb), and one end of each of the second strings is coupled to each of the second bit lines,
the CMOS layer includes a plurality of sense amplifier units (SAU) configured to be able to determine data, the sense amplifier units are respectively coupled to the first bit lines and are respectively coupled to the second bit lines, each of the sense amplifier units includes a first transistor (T9a) coupled to any of the first bit lines, a second transistor (T9b) coupled to any of the second bit lines, and a sense node (SEN) coupled to each of the first transistor and the second transistor, and the sense amplifier units includes a plurality of first sense amplifier units and a plurality of second sense amplifier units,
in the read operation, the sequencer is configured to:
apply a voltage of a first logic level ("H") to the first transistor of each of the first sense amplifier units, and apply a voltage of a second logic level ("L") different from the first logic level to the second transistor of each of the first sense amplifier units, and
apply a voltage of the second logic level to the first transistor of each of the second sense amplifier units, and apply a voltage of the first logic level to the second transistor of each of the second sense amplifier units.

10. The memory device of claim 9, wherein
the sequencer is further configured to:
in the first read operation, control to turn on each of the first transistor of the first sense amplifier unit and the second transistor of the second sense amplifier unit, and control to turn off each of the second transistor of the first sense amplifier unit and the first transistor of the second sense amplifier unit, and
in the second read operation, control to turn on each of the second transistor of the first sense amplifier unit and the first transistor of the second sense amplifier unit, and control to turn off each of the first transistor of the first sense amplifier unit and the second transistor of the second sense amplifier unit.

11. The memory device of claim 9, wherein
each of the first strings includes a first memory cell (MTa), a third transistor (STae), and a fourth transistor (STao) coupled in series, the first memory layer further includes a first wiring (SGae), a second wiring (SGao), and a first word line (WL/22a), the first wiring is coupled to the third transistor of each of the first strings, the second wiring is coupled to the fourth transistor of each of the first strings, and the first word line is coupled to the first memory cell of each of the first strings,
each of the second strings includes a second memory cell (MTb), a fifth transistor (STbe), and a sixth transistor (STbo) coupled in series, the second memory layer further includes a third wiring (SGbe), a fourth wiring (SGbo), and a second word line (WL/22b), the third wiring is coupled to the fifth transistor of each of the second strings, the fourth wiring is coupled to the sixth transistor of each of the second strings, and the second word line is coupled to the second memory cell of each of the second strings and is electrically coupled to the first word line, and
the sequencer is further configured to
in a first read operation in which the first and second word lines are selected, apply a first voltage (VMID) to the first wiring, apply a second voltage (VREAD) higher than the first voltage to the second wiring, apply the first voltage to the third wiring, and apply the second voltage to the fourth wiring.

12. The memory device of claim 11, wherein
the sequencer is further configured to
in a second read operation in which the first and second word lines are selected, apply the second voltage to the first wiring, apply the first voltage to the second wiring, apply the second voltage to the third wiring, and apply the first voltage to the fourth wiring.

13. The memory device of claim 11, wherein
in an even first string (NSae) coupled to an even first bit line (BLae) among the first strings, a threshold voltage of the third transistor is lower than a threshold voltage of the fourth transistor,
in an odd first string (NSao) coupled to an odd first bit line (BLao) among the first strings, a threshold voltage of the third transistor is higher than a threshold voltage of the fourth transistor,
in an even second string (NSbe) coupled to an even second bit line (BLbe) among the second strings, a threshold voltage of the fifth transistor is higher than a threshold voltage of the sixth transistor, and
in an odd second string (NSbo) coupled to an odd second bit line (BLbo) among the second strings, a threshold voltage of the fifth transistor is lower than a threshold voltage of the sixth transistor.

14. The memory device of claim 13, wherein
the first voltage is between a threshold voltage of the third transistor and a threshold voltage of the fourth transistor in the even first string, between a threshold voltage of the third transistor and a threshold voltage of the fourth transistor in the first odd string, between a threshold voltage of the fifth transistor and a threshold voltage of the sixth transistor in the second even string, and between a threshold voltage of the fifth transistor and a threshold voltage of the sixth transistor in the second odd string, and
the second voltage is higher than a threshold voltage of the fourth transistor in the even first string, higher than a threshold voltage of the third transistor in the odd first string, higher than a threshold voltage of the fifth transistor in the even second string, and higher than a threshold voltage of the sixth transistor in the odd second string.

15. The memory device of claim 9, wherein
each of the sense amplifier units includes a seventh transistor (T10a) coupled to any of the first bit lines, an eighth transistor (T10b) coupled to any of the second bit lines, and a first node coupled to each of the seventh transistor and the eighth transistor, and
in the read operation, the sequencer is configured to
apply a voltage of the second logic level to each of the seventh transistor and the eighth transistor of each of the sense amplifier units.
